(19) Europäisches Patentamt
European Patent Office
Office européen des brevets

(11) EP 3 476 590 A1

(12) **EUROPEAN PATENT APPLICATION**
published in accordance with Art. 153(4) EPC

(43) Date of publication:
**01.05.2019 Bulletin 2019/18**

(21) Application number: **17885982.3**

(22) Date of filing: **28.12.2017**

(51) Int Cl.:
***B32B 15/04*** *(2006.01)*
***B32B 5/18*** *(2006.01)*
***B32B 9/04*** *(2006.01)*
***B32B 15/08*** *(2006.01)*
***C08J 9/00*** *(2006.01)*
***C08K 5/092*** *(2006.01)*

(86) International application number:
**PCT/KR2017/015695**

(87) International publication number:
**WO 2018/124792 (05.07.2018 Gazette 2018/27)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(30) Priority: **28.12.2016 KR 20160181435**
**12.01.2017 KR 20170005045**

(71) Applicant: **Tegway Co., Ltd.**
**Daejeon 34051 (KR)**

(72) Inventors:
- **YI, Kyoung Soo**
  **Daejeon 34207 (KR)**
- **LIM, Se Hwan**
  **Daejeon 34139 (KR)**

(74) Representative: **D Young & Co LLP**
**120 Holborn**
**London EC1N 2DY (GB)**

(54) **COMPOSITION FOR FOAM, FLEXIBLE THERMOELECTRIC ELEMENT, DUCTILE CONDUCTIVE LAMINATE, AND METHOD FOR MANUFACTURING SAME**

(57) The present invention includes a foam composition including a foam precursor and an ortho-phthalate-based compound, wherein a volume ratio of the foam precursor to the ortho-phthalate-based compound is 100 : 10 to 50, and a flexible thermoelectric device including the foam manufactured thereby.

【Fig. 1】

(a)

(b)

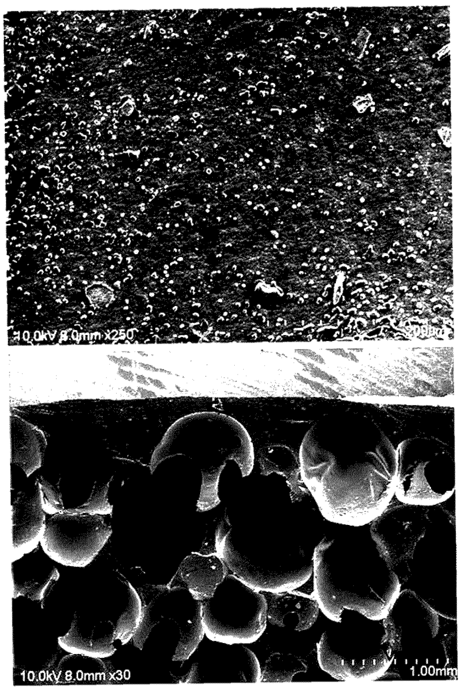


EP 3 476 590 A1

## Description

[Technical Field]

Foam composition, flexible thermoelectric device, flexible conductive laminate and production method thereof

[Background Art]

Foams refer to porous materials in the form of a sponge, which is manufactured by a foaming process, and are classified into two large groups of flexible polyurethane-based foams and rigid foams.

Flexible polyurethane-based foams have a soft body and are restored to their original shapes even if they are deformed by an external force, and therefore are used as a cushion or a sound-absorbing material. Rigid foams have a hard body and are difficult to restore to their original shapes when deformed by an external force, and therefore are mainly used as an insulator or a filler.

In other words, a laminate conventionally used for thermal insulation is decreased in flexibility due to the use of a rigid foam for an excellent thermal insulating effect, and damaged when a high level of physical deformation is applied, and therefore there is a limit for application to a flexible conductive device.

Meanwhile, a thermoelectric effect is an effect in which thermal energy and electric energy are directly converted into each other through interaction and is a generic term for the Seebeck effect discovered by Thomas Johann Seebeck and the Peltier effect discovered by Jean Charles Peltier. A device exhibiting such a thermoelectric effect is referred to as a thermoelectric device.

The thermoelectric device includes a thermoelectric power generating device using the Seebeck effect which converts thermal energy into electrical energy, and a cooling device using the Peltier effect which converts electrical energy into thermal energy, and the like. The thermoelectric device is a material and a technique which best meets the demands of energy saving. It is widely used in fields such as automobile industry, aerospace industry, semiconductor industry, biotechnology industry, optic industry, computer industry, power generation industry, household appliance industry, and the like, and efforts to improve thermal efficiency are being conducted by research institutes and universities.

Generally, a thermoelectric device is manufactured by forming a second electrode on a ceramic lower substrate such as alumina ($Al_2O_3$), forming a thermoelectric material made of N-type and P-type semiconductors on a surface of the second electrode, and connecting the N-type thermoelectric material and the P-type thermoelectric material in series through a first electrode. However, such a thermoelectric device is either a cascade type thermoelectric device or a segment type thermoelectric device, and thus it is difficult to change a shape of the thermoelectric device, and a ceramic substrate made of alumina ($Al_2O_3$) or alumina nitride (AlN) or a metal substrate coated with a nonconductor thin film, which have no flexible characteristic, is used such that it is difficult to apply the thermoelectric device to fields demanding flexibility.

Further, a weight of the substrate is heavy and thus the thermoelectric device is not suitable for fields of a physical fitness body field, an automobile field, an aerospace field, and the like, which demand weight reduction, and the P type and N type thermoelectric materials are formed in a bulky shape to have lengths in the range of 1 mm to several tens of millimeters, but a heat loss due to upper and lower substrates is large.

Furthermore, Korean Patent Registration No. 10-1646366 disclosed a thermoelectric module structure in which silicone is poured and a P-type pellet and an N-type pellet are inserted into the poured portion to improve durability against vibration. However, in such a case, since the silicone is located between an electrode and a thermoelectric material thus causing thermal conductivity to increase, it is difficult to secure a temperature difference between both ends of the thermoelectric device, and also there is a fatal problem in that heat loss occurs moving from the thermoelectric material toward the silicone and thus performance of the thermoelectric device is degraded, and due to a characteristic of the silicone which is an inorganic material, attempting to secure flexibility of a curved portion by providing grooves at the silicone has a disadvantage in that overall flexibility of the thermoelectric device is degraded.

Meanwhile, the applicant of the present invention has disclosed in Korean Patent Registration No. 10-1493797 has been proposed that a substrate is not located on an upper portion and/or a lower portion of a thermoelectric device and a non-conductive flexible mesh that is supported passing through a thermoelectric material leg array such that mechanical stability and flexibility can be simultaneously secured.

The disclosed thermoelectric device has a characteristic of high power generation and high flexibility, but due to a polymer material filling in a space between an N-type thermoelectric material and a P-type thermoelectric material of the thermoelectric device so as to secure mechanical stability, thermal conductivity between an electrode and the thermoelectric materials increases and thus heat loss occurs, such that there is a problem in that the heat-electricity conversion efficiency is somewhat degraded.

For this reason, it is necessary to develop a flexible thermoelectric device which has excellent heat-electricity conversion efficiency and an excellent insulating effect by ensuring high flexibility and mechanical stability and considerably lowering thermal conductivity, and a flexible conductive laminate which can maintain long-term mechanical stability due to an excellent insulating effect, high flexibility and a high restoring force, and high adhesive strength between a metal film and a foam.

[Disclosure]

[Technical Problem]

The present invention is directed to providing a foam composition and a flexible thermoelectric device having very high heat-electricity conversion efficiency using an intermediate filler material that has remarkably low thermal conductivity in addition to having high flexibility and mechanical stability, and high adhesive strength between internal components, and a production method therefor.

The present invention is also directed to providing a flexible conductive laminate which has an excellent thermal insulating effect, high flexibility and a high restoring force, and high adhesive strength between a metal film and a foam, and a production method thereof.

[Technical Solution]

To attain the above-mentioned objects, one aspect of the present invention provides a foam composition, which includes a foam precursor, and an ortho-phthalate-based compound represented by the following Formula 1, and a volume ratio of the foam precursor to the ortho-phthalate-based compound is 100 : 10 to 50.

[Formula 1]

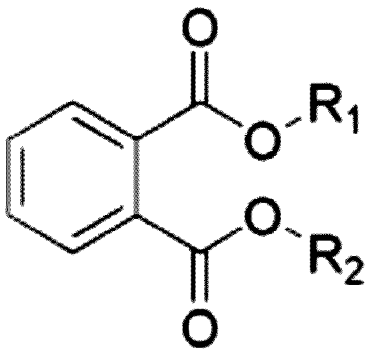

(In Formula 1, $R_1$ and $R_2$ are each independently any one selected from alkyl having 1 to 20 carbon atoms, cycloalkyl having 6 to 30 carbon atoms, aryl having 6 to 30 carbon atoms, cycloalkylalkyl having 7 to 30 carbon atoms, arylalkyl having 7 to 30 carbon atoms, aryl having 6 to 20 carbon atoms, which is substituted with alkyl having 1 to 10 carbon atoms, and alkyl having 1 to 10 carbon atoms, which is substituted with aryl having 6 to 20 carbon atoms.)

In addition, another aspect of the present invention provides a flexible thermoelectric device which includes a foam manufactured from the foam composition.

In addition, still another aspect of the present invention provides a method of manufacturing a flexible thermoelectric device, which includes forming a foam by foaming the foam composition.

In addition, yet another aspect of the present invention provides a flexible conductive laminate which includes a metal film, and a flexible polyurethane-based foam formed on one surface of the metal film.

In addition, yet another aspect of the present invention provides a method of manufacturing a flexible conductive laminate, which includes: a) forming a metal film on a sacrificial substrate; b) forming a flexible polyurethane-based foam on the metal film; and c) removing the sacrificial substrate.

[Advantageous Effects]

A foam composition according to one embodiment of the present invention is a composition for forming a foam filled in a flexible thermoelectric device, which can be controlled to have viscosity in a suitable range by containing an ortho-phthalate-based compound in a suitable range, and compared to that when an ortho-phthalate-based compound is not contained, the time for foaming the foam composition is delayed, thereby solving a problem of starting foaming

before the foam composition is injected into empty spaces in the array of thermoelectric material legs.

Therefore, as the foam composition is not only easily injected into empty spaces in the array of thermoelectric material legs, but also is fully injected into the empty spaces, an electrode and a foam, and a thermoelectric material and the foam can be well adhered without gaps, thereby enhancing adhesive strengths after foaming.

In addition, as a volume change caused by foaming the composition in the form of a foam is controlled to a suitable level by controlling an amount of a foam precursor contained in the composition injected into the empty spaces in the array of thermoelectric material legs in a suitable range, the damage to a thermoelectric device can be prevented.

In addition, when a polyurethane precursor having an aromatic group is used, the ortho-phthalate-based compound cannot be easily phase-separated with the polyurethane precursor or cannot migrate due to an interaction between an ortho-phthalate-based compound represented by Formula 1 and the aromatic group of the polyurethane precursor, and thus the stability of the composition can be enhanced.

In addition, because of excellent adhesive strengths between a foam and an electrode and between a foam and a thermoelectric material by filling a flexible thermoelectric device with the foam, a glass frit essentially added to the electrode or thermoelectric material for enhancing adhesive strength can be excluded. Since the glass frit with low electrical conductivity can be excluded, efficiency of thermoelectric power generation of the thermoelectric device can be more enhanced, and a method of manufacturing a thermoelectric device can be greatly simplified by forming the electrode or thermoelectric material without using a paste.

Specifically, since a polyurethane foam is used as the foam, the adhesive strength between the foam and the electrode and between the foam and the thermoelectric material can be significantly improved while high flexibility and high mechanical stability can also be ensured, and a filling material can have a significantly low thermal conductivity of 0.05 W/m·K or less which is a level approaching a thermal conductivity of air.

Further, a flexible thermoelectric device can have remarkably low thermal conductivity using a foam as a filling material for filling a void of an array of thermoelectric material legs, thereby remarkably improving a temperature gradient of the flexible thermoelectric device and efficiency of thermoelectric power generation.

Furthermore, weight reduction of the flexible thermoelectric device can be achieved due to a foam structure, and the flexible thermoelectric device can have high flexibility as well as absorb an externally applied physical impact due to a high elasticity property, such that the flexible thermoelectric device can be prevented from being damaged by the physical impact and high mechanical stability can be secured.

A flexible conductive laminate according to another exemplary embodiment of the present invention includes a flexible polyurethane-based foam, thereby having an excellent thermal insulating effect.

In addition, since an allowable radius of curvature is very small, for example, 5 mm or less, the flexible conductive laminate may have very excellent flexibility, and even if a high level of physical deformation is repeatedly applied, due to a very excellent restoring force, the shape of the laminate can be prevented from being changed.

Moreover, due to the excellent adhesive strength between the metal film and the flexible polyurethane-based foam, the metal film and the flexible polyurethane-based foam cannot be easily separated, and thus the shape of the laminate can be stably maintained for a long time.

Therefore, when the flexible conductive foam is applied to a flexible conductive device, even in an environment in which a high level of physical deformation is repeatedly applied, the mechanical stability of the device can be maintained, and thus the device can be stably operated for a long time, resulting in enhancement of the reliability of the device.

[Description of Drawings]

FIG. 1 is a set of images showing the outer surface of the polyurethane foam adhered to an electrode or a metal film, and the inner cross-section of the polyurethane foam.

FIG. 2 is a cross-sectional view of a flexible thermoelectric device according to one embodiment of the present invention.

FIG. 3 is a diagram showing a void structure of a foam according to one embodiment of the present invention.

FIG. 4 is a set of images showing flexible thermoelectric devices manufactured according to Example 1 and Comparative Example 7.

FIG. 5 is a graph showing the internal resistance variation (%) of a device according to the radius of curvature of the flexible thermoelectric devices manufactured according to Example 1 and Comparative Example 7.

FIG. 6 is a schematic flowchart of a method of manufacturing a flexible thermoelectric device according to one embodiment of the present invention.

FIG. 7 is a cross-sectional view of a flexible conductive laminate according to one embodiment of the present invention.

FIG. 8 is a cross-sectional view of a flexible conductive laminate according to another embodiment of the present

invention.

[Best Modes of the Invention]

Hereinafter, exemplary embodiments of the present invention will be described in detail with reference to the accompanying drawings.

The following drawings are provided as examples so as to fully convey the spirit of the present invention to those skilled in the art. Therefore, the present invention is not limited to the following drawings but may be implemented in other forms. The following drawings may be exaggerated in order to clarify the spirit of the present invention. Further, like reference numerals designate like elements throughout the present invention.

At this point, unless otherwise defined in technical and scientific terms used herein, meanings which are commonly understood by those skilled in the art to which the present invention pertains, and descriptions of well-known functions and configurations which may unnecessarily obscure the gist of the present invention in the following description and the accompanying drawings will be omitted.

Hereinafter, with reference to FIGS. 1 to 6, a foam composition of the present invention and a flexible thermoelectric device including the foam manufactured therefrom will be described in detail.

Unless particularly defined otherwise, the "composition" used herein refers to a foam composition, which may be a composition for manufacturing a foam before being foamed into a foam. In addition, the "empty spaces in the array of thermoelectric material legs" may mean an empty space in a device before a foam composition is injected.

The applicant of the present invention has disclosed in Korean Patent Registration No. 10-1493797 has been proposed that a substrate is not located on an upper portion and/or a lower portion of a thermoelectric device and a non-conductive flexible mesh is supported passing through a thermoelectric material leg array such that mechanical stability and flexibility can simultaneously be secured.

The disclosed thermoelectric device has a characteristic of high power generation and high flexibility, but due to a polymer material filling in a space between an N-type thermoelectric material and a P-type thermoelectric material of the thermoelectric device so as to secure mechanical stability, thermal conductivity between an electrode and the thermoelectric materials increases and thus heat loss occurs, such that there is a problem in that the heat-electricity conversion efficiency is somewhat degraded.

To overcome these limitations, as a result of long-term repeated studies on a material for filling empty spaces in the array of thermoelectric material legs, which has significantly low thermal conductivity, the excellent adhesive strength between an electrode and a thermoelectric material, and excellent flexibility, it was found that, when a foam is used as a filling material, all of low thermal conductivity, excellent adhesive strength and flexibility, and high mechanical stability can be ensured.

Particularly, it was found that, when an ortho-phthalate-based compound having a specific structure is added to a composition for manufacturing a foam in a suitable range, the composition can be very easily injected into the electrode and empty spaces in the array of thermoelectric material legs due to a significantly low viscosity of the composition, and as the time for foaming the foam composition is delayed, compared to the case in which the ortho-phthalate-based compound is not added, a problem of starting foaming before empty spaces in the array of thermoelectric material legs are filled with the foam composition can be solved, the adhesive strength between the foam and the electrode can be further enhanced, and the damage to a thermoelectric device in a foaming process can be prevented, and thus the present invention was completed.

First, a flexible thermoelectric device according to the present invention will be described.

The flexible thermoelectric device according to the present invention includes a foam manufactured from a foam composition, and in other words, the flexible thermoelectric device according to the present invention may include a foam formed by foaming the foam composition.

Specifically, a flexible thermoelectric device may include an array of thermoelectric material legs containing at least one N-type thermoelectric material and at least one P-type thermoelectric material which are spaced apart from each other, an electrode configured to electrically connect the thermoelectric materials of the array of thermoelectric material legs, and a foam configured to fill in at least one void between the array of thermoelectric material legs.

The foam is a filling material filling empty spaces in the array of thermoelectric material legs, and due to a characteristic of a thermoelectric device, a temperature gradient between an electrode directly in contact with a heat source and an electrode formed to face the above-described electrode (e.g., when a first electrode is in contact with the heat source, an electrode facing the first electrode is a second electrode) is preferable to be large, such that it is preferable that the foam is a material having low thermal conductivity. That is, it is preferable that the foam is a material having flexibility as well as low thermal conductivity and ensuring sufficient mechanical and physical strength by being adhered to the electrode.

More specifically, the foam according to one embodiment of the present invention may be a flexible polymer foam having a plurality of fine pores containing one or more gases selected from among low thermal conductivity air,

carbon dioxide, nitrogen, argon, krypton, xenon, and ammonia. The gas such as air, carbon dioxide, nitrogen, argon, krypton, xenon, or ammonia is a representative material having very low thermal conductivity, and when a foam containing such a gas is used as a filling material, the filling material may have very low thermal conductivity and a temperature gradient of a thermoelectric device may significantly be improved, such that efficiency of thermoelectric power generation may significantly be improved. Further, weight reduction of the flexible thermoelectric device may be achieved due to a foam structure, and flexibility as well as elasticity are high and thus an externally applied physical impact may be absorbed, such that the flexible thermoelectric device may be prevented from being damaged by the physical impact and high mechanical stability can be secured.

Specifically, the foam may be a polymer foam. More specifically, the foam may be a flexible polymer foam in the form of a sponge having flexibility and stretchability. Accordingly, the flexible thermoelectric device may have significantly low thermal conductivity and high flexibility, and, at the same time, the foam may also absorb a portion of an external force even when the external force is repeatedly applied, such that damages to the filling material, the electrode, and the thermoelectric material may be prevented and the flexible thermoelectric device may operate stably for a long period of time.

In one embodiment of the present invention, the foam is not particularly limited as long as it is a polymer foam having flexibility and low thermal conductivity, and specifically, for example, the foam may have thermal conductivity of 20% or less relative to the thermoelectric material, and the foam having thermal conductivity in the range of 0.1 to 10% relative to that of the thermoelectric material may be used to effectively block heat transfer and secure thermal stability.

More specifically, the foam according to the present invention may have thermal conductivity of 0.1 W/m·K or less, more preferably 0.08 W/m·K or less, and even more preferably 0.05 W/m.K or less. As described above, since the thermal conductivity is very low, the heat transfer may effectively be blocked and thus the thermal stability may be secured. At this point, a lower limit of the thermal conductivity is not particularly limited, and thermal conductivity of the gas contained in the foam may be considered as the lower limit.

At this time, the foam may be formed by foaming the foam composition by a conventional foaming method, and any method known in the art may be used as long as it is a foaming method capable of satisfying physical properties required for a foam in the present invention.

Specifically, the foam composition according to one embodiment of the present invention is a composition for forming a foam, which is injected into a flexible thermoelectric device, and includes a foam precursor, and an ortho-phthalate-based compound represented by Formula 1 below, wherein a volume ratio of the foam precursor to the ortho-phthalate-based compound may be 100 : 10 to 50.

[Formula 1]

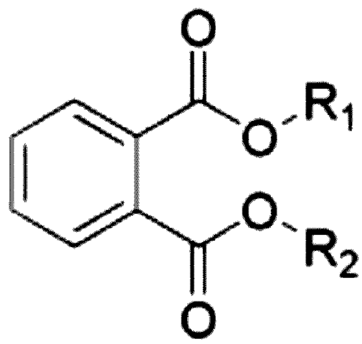

(In Formula 1, $R_1$ and $R_2$ are each independently any one selected from alkyl having 1 to 20 carbon atoms, cycloalkyl having 6 to 30 carbon atoms, aryl having 6 to 30 carbon atoms, cycloalkylalkyl having 7 to 30 carbon atoms, arylalkyl having 7 to 30 carbon atoms, aryl having 6 to 20 carbon atoms, which is substituted with alkyl having 1 to 10 carbon atoms, and alkyl having 1 to 10 carbon atoms, which is substituted with aryl having 6 to 20 carbon atoms.)

As such, the ortho-phthalate-based compound satisfying Formula 1 may be contained in a suitable range to control the composition to have a suitable range of viscosity, and as the time for foaming the foam composition is delayed, compared to that when the ortho-phthalate-based compound is not added, a problem of starting foaming before empty spaces in the array of thermoelectric material legs are filled with the foam composition can be solved. Accordingly, as the foam composition is not only easily injected into empty spaces in the array of thermoelectric material legs, but also is fully injected into the empty spaces, an electrode and a foam, and a thermoelectric material and the foam can be well adhered without gaps, thereby enhancing adhesive strength after foaming.

In addition, as a volume change caused by foaming the composition in the form of a foam is controlled to a

suitable level by controlling an amount of a foam precursor contained in the composition injected into the empty spaces in the array of thermoelectric material legs in a suitable range, the damage to a thermoelectric device may be prevented.

Moreover, when a polyurethane precursor having an aromatic group is used, the ortho-phthalate-based compound may not be easily phase-separated with the polyurethane precursor or may not migrate due to an interaction between an ortho-phthalate-based compound represented by Formula 1 and the aromatic group of the polyurethane precursor, and thus the stability of the composition may be enhanced. On the other hand, when only an aromatic group-free aliphatic group or alicyclic group compound is added, phase-separation of the foam precursor and the aliphatic or alicyclic compound or migration may occur.

In addition, since there is no functional group capable of being chemically reacting with a polymer or prepolymer for forming a foam and a foaming agent, the foam composition never participates in a foaming reaction between a polymer and a foam or polymerization between prepolymers, and thus the unique physical properties of the foam may not be degraded. In one embodiment, when the foam is a polyurethane-based foam, polyethylene glycol conventionally added to control a viscosity is reacted with a diisocyanate compound, and thus the polyethylene glycol is located in the main chain of a polyurethane resin and thus affects the unique physical properties of the polyurethane resin. However, as the present invention uses the ortho-phthalate-based compound satisfying Formula 1 as an additive for controlling viscosity, a reaction with a diisocyanate compound in urethane polymerization may be prevented, and therefore the physical properties such as flexibility of the polyurethane resin may be completely maintained.

Preferably, in the ortho-phthalate-based compound represented by Formula 1 according to one embodiment of the present invention, $R_1$ and $R_2$ may be each independently any one selected from alkyl having 1 to 10 carbon atoms, cycloalkyl having 6 to 20 carbon atoms, aryl having 6 to 20 carbon atoms, cycloalkylalkyl having 7 to 20 carbon atoms, and arylalkyl having 7 to 20 carbon atoms.

More preferably, in the ortho-phthalate-based compound represented by Formula 1 according to one embodiment of the present invention, $R_1$ may be alkyl having 1 to 10 carbon atoms, and $R_2$ may be aryl having 6 to 20 carbon atoms or arylalkyl having 7 to 20 carbon atoms. The use of the ortho-phthalate-based compound may more effectively prevent the phase-separation between the foam precursor and the ortho-phthalate-based compound.

Meanwhile, as described above, the ortho-phthalate-based compound represented by Formula 1 is added to control the viscosity of the foam composition and delay the foaming time, and when the foam precursor is mixed with the ortho-phthalate-based compound in a volume ratio of 100 : 10 to 50, the composition may have a viscosity in a suitable range and a sufficiently delayed foaming time, and therefore the composition may be easily injected into empty spaces in the array of thermoelectric material legs. The volume ratio of the foam precursor: the ortho-phthalate-based compound is preferably 100 : 15 to 45, more preferably, 100 : 20 to 40, and even more preferably 100 : 25 to 40. Within this range, the composition may have a suitable range of viscosity, the time for foaming the foam composition may be sufficiently delayed, compared to that when the ortho-phthalate-based compound is not added, and therefore foaming may occur after empty spaces in the array of thermoelectric material legs are fully filled with the foam composition. In addition, as the composition is foamed into a foam, a volume change is controlled to a suitable level, and thus the damage to a thermoelectric device may be prevented. On the other hand, when the mixing proportion of the ortho-phthalate-based compound to the foam precursor is very low, foaming may occur while empty spaces in the array of thermoelectric material legs are not fully filled with the foam composition, and when the mixing proportion of the ortho-phthalate-based compound to the foam precursor is very high, mechanical properties and adhesive strength of the foam may be degraded after foaming.

More specifically, the viscosity according to the addition of the ortho-phthalate-based compound represented by Formula 1 may be, for example, 800 cps or less. When the viscosity is more than 800 cps, the composition is not easily injected into empty spaces in the array of thermoelectric material legs, and thus the empty spaces may not be completely filled. In this case, an adhesive area between the foaming agent and the electrode or the foam and the thermoelectric material after foaming may be reduced, thereby degrading adhesive strength. Specifically, the viscosity of the composition may be 100 to 800 cps, preferably 100 to 650 cps, and more preferably 250 to 550 cps. At this time, the viscosity of the foam composition may be a value calculated by the following viscosity calculation formula. Since the foam composition includes a prepolymer, a crosslinking agent, a foaming agent, etc., polymerization and the foaming process may start within several minutes after the preparation of the composition. Therefore, before each component is mixed, a viscosity of each component is measured, and then the viscosity may be calculated by the viscosity calculation formula, or viscosity data given from a data sheet is applied to the viscosity calculation formula, thereby calculating the viscosity.

[Viscosity calculation formula]

$$\log z = A \log x + B \log y$$

Specifically, when a mixed solution is prepared by mixing a first solution and a second solution, z is the viscosity of the mixed solution (cps), x is the viscosity of the first solution (cps), y is the viscosity of the second solution (cps), A is a mixing proportion of the first solution, and B is a mixing proportion of the second solution, where A+B=1.

In addition, the foaming delay time according to the addition of the ortho-phthalate-based compound represented by Formula 1 is not particularly limited, but may be 60 seconds or more. That is, the foam composition may be foamed 60 seconds, preferably 90 seconds or more, and more preferably 120 to 300 seconds after the preparation of the composition. On the other hand, when the ortho-phthalate-based compound is not added, foaming occurs approximately 40 seconds after the preparation of the composition, and thus there is a difficulty in very rapidly filling empty spaces in the array of thermoelectric material legs with the foam composition.

Meanwhile, the foam precursor according to one embodiment of the present invention is a material for substantially forming a foam, and the foam may be formed by performing a foaming process on the composition including the foam precursor.

According to one embodiment of the present invention, the foam precursor is not particularly limited as long as it is a material capable of forming a foam having flexibility and low thermal conductivity after foaming, but a material which can satisfy the required properties of an intended foam may be used. Specifically, the foam precursor may be selected in consideration of flexibility, physical strength, degree of foaming, air porosity, and the like of the foam.

The foam precursor for forming a foam may include a polymer or prepolymer, and a foaming agent.

In other words, the foam may be formed by foaming the polymer or prepolymer. The prepolymer is a compound with a relatively low degree of polymerization, which contains a curable functional group (curable group), and may mean a prepolymer or monomer before curing and foaming after empty spaces in the array of thermoelectric material legs are filled, and a filling material injected into the flexible thermoelectric device may be formed by partially or totally curing the curable group of the prepolymer. In other words, a compound which is not cured after being injected into empty spaces in the array of thermoelectric material legs is called a prepolymer, and a compound which is subjected to curing and foaming is called a filling material or foam. In addition, when a foam is formed using a polymer, the polymer may be injected into empty spaces in the array of thermoelectric material legs, but in a state before foaming, and may be formed by polymerizing a prepolymer.

Specifically, in one exemplary embodiment of the present invention, the foam prepared from the foam composition may be any polymer foam without particular limitation, as long as it has flexibility and low thermal conductivity, but in a non-limiting embodiment, the foam prepared from the foam composition may be a polyurethane-based foam, a silicone-based foam or a polyolefin-based foam.

FIG. 1 is a set of images showing the outer surface of the polyurethane foam adhered to an electrode or a metal film, and the inner cross-section of the polyurethane foam. Referring to FIG. 1, in the upper image of FIG. 1, it can be seen that a dense polyurethane film is formed on the outer surface of the polyurethane foam, which is adhered to an electrode, and in the lower image of FIG. 1, it can be seen that polyurethane is foamed into the polyurethane foam to create a void structure. Here, an example of the void structure of the foam, as shown in FIG. 3, may be a honeycomb-shaped structure. FIG. 3 is a diagram showing a void structure of a foam according to one embodiment of the present invention.

The usage of the foam as the filling material of the thermoelectric device may effectively block heat transfer between upper and lower electrodes and minimize a heat loss from the thermoelectric material such that thermoelectric efficiency of the thermoelectric device may be improved, flexibility and elasticity are high, a change in physical properties is low according to a temperature, and flexibility is maintained in a wide temperature range, such that the thermoelectric device may not be damaged due to frequent physical deformation and thus a lifetime of the thermoelectric device may be lengthened.

Specifically, the polyurethane-based foam may be manufactured from a urethane-based foam precursor, and the urethane-based foam precursor may be classified into a first form in which a polymer is formed by an addition condensation reaction of an isocyanate group (-NCO) and a hydroxyl group (-OH) in the presence of a catalyst, and a second form in which a polymer is formed by an addition reaction of a urethane-based prepolymer containing an unsaturated group and a crosslinking agent.

More specifically, the first form may form the polymer as a result of a reaction of a polyisocyanate-based compound containing two or more isocyanate groups with a polyol-based compound containing two or more hydroxy groups.

In one embodiment, the polyisocyanate-based compound may include one or two or more compounds selected from the group consisting of aromatic polyisocyanate, aliphatic polyisocyanate, and alicyclic polyisocyanate. More specifically, the aromatic polyisocyanate may include 1,3-phenylene diisocyanate, 1,4-phenylene diisocyanate, 2,4-tolylene diisocyanate (TDI), 2,6-tolylene diisocyanate, 4,4'-diphenylmethane diisocyanate (MDI), 2,4-diphenylmethane diisocyanate, 4,4'-diisocyanatobiphenyl, 3,3'-dimethyl-4,4'-diisocyanatobiphenyl, 3,3'-dimethyl-4,4'-diisocyanatodiphenylmethane, 1,5-naphthylene diisocyanate, 4,4', 4"-triphenylmethane triisocyanate, m- isocyanatophenylsulfonyl isocyanate, and p-isocyanatophenylsulfonyl isocyanate, the aliphatic polyisocyanate may include ethylene diisocyanate, tetramethylene diisocyanate, hexamethylene diisocyanate (HDI), dodecamethylene diisocyanate, 1,6,11-undecane triisocyanate, 2,2,4-trimethylhexamethylene diisocyanate, lysine diisocyanate, 2,6-diisocyanatomethyl caproate, bis(2-isocyanatoethyl)fumarate, bis(2-isocyanatoethyl) carbonate, and 2-isocyanatoethyl-2,6-diisocyanatohexanoate, the alicyclic polyisocyanate may include isophorone diisocyanate (IPDI), 4,4'-dicyclohexylmethane diisocyanate (hydrogenated MDI), cyclohexylene diisocyanate, methylcyclohexylene diisocyanate (hydrogenated TDI), bis(2-isocyanatoethyl) -4-dicyclohexene-1,2-dicarboxylate, 2,5-norbornane diisocyanate, and 2,6-norbornane diisocyanate, but they are not particularly limited thereto.

The polyol-based compound is not particularly limited as long as it is capable of forming flexible polyurethane foam having high flexibility, and specifically, may include polyester polyol, polyether polyol, and a mixture thereof. As a non-limiting example, the polyester polyol may be polyethylene adipate, polybutylene adipate, poly (1,6-hexadipate), polydiethylene adipate, or poly (e-caprolactone), and as a non-limiting example, the polyether polyol may be polyethylene glycol, polydiethylene glycol, polytetramethylene glycol, and polyethylene propylene glycol, but the present invention is not limited thereto. The polyether polyol having a flexible structure may be preferable in terms of further improving flexibility of the foam. In this case, the catalyst is not particularly limited as long as it is commonly used in the art, but may include an amine-based catalyst, and as a non-limiting example, dimethylcyclohexylamine (DMCHM), tetramethylenediamine (TMHDA), pentamethylene Diethylenediamine (PMEDETA), or tetraethylenediamine (TEDA) may be used. A molecular weight of the polyol is not particularly limited as long as it is capable of forming flexible polyurethane, and for example, the molecular weight of the polyol may be a compound having a number average molecular weight of in the range of 500 to 20,000 g/mol, more preferably in the range of 800 to 10,000 g/mol, even more preferably in the range of 1,000 to 5,000 g/mol. A soft segment property of the polyurethane-based foam may be improved in the above-described ranges to improve flexibility and elasticity, and possibility of occurrence of defects such as cracks and the like occurring during the curing and foaming may be minimized.

Further, the second form may form the polymer from an addition reaction between a urethane-based prepolymer containing an ethylenic unsaturated group and the crosslinking agent. The urethane-based prepolymer may have various structures varied according to kinds of an isocyanate group-containing compound and a polyol-based compound, but the urethane-based prepolymer may be an ethylenic unsaturated group, more specifically, a urethane prepolymer containing a vinyl group. As a specific example, 2 to 20 vinyl groups may be contained in a single polyurethane chain, but are not limited thereto, and as the molecular weight of the polyurethane increases, the vinyl group may proportionally increase to more than 20 groups, and polyurethane having a low molecular weight may include 2 to 4 vinyl groups. In this case, the crosslinking agent may be a vulcanizing agent, and the vulcanizing agent is not limited as long as it is commonly used in the art, and as a non-limiting example, sulfur or organic peroxide may be used.

The silicone-based foam may be made from a silicone-based foam precursor, and in this case, the silicone-based foam precursor may include aliphatic polysiloxane and an aromatic polysiloxane which has two or more hydroxy groups, or a condensation type silicone-based prepolymer such as polysiloxane containing an aliphatic group and an aromatic group in one repeat unit or siloxane repeating units independently having the aliphatic group and the aromatic group. In this case, 2 to 20 hydroxyl groups may be included in a single polysiloxane chain, but are not limited thereto, and as a molecular weight of the polysiloxane increases, the hydroxy group may proportionally increase to more than 20, and polysiloxane having a low molecular weight may preferably include 2 to 4 hydroxyl groups. As a specific non-limiting example, the aliphatic polysiloxane may be selected from the group consisting of polydimethylsiloxane, polydiethylsiloxane, polymethylethylsiloxane, polydimethylsiloxane-co-diethylsiloxane, and polydimethylsiloxane-co-ethylmethylsiloxane which each contain two or more hydroxyl groups, and the aromatic polysalic acid may be selected from the group consisting of polydiphenylsiloxane, polymethylphenylsiloxane, polyethylphenylsiloxane, and poly(dimethylsiloxane-co-diphenylsiloxane) which each contain two or more hydroxy groups. The polysiloxane containing a siloxane repeat unit containing both the aliphatic group and the aromatic group in one repeat unit or independently containing the aliphatic group and the aromatic group may include both a repeat unit of the exemplified aliphatic siloxane and a repeat unit of the aromatic siloxane or may refer to a form in which the exemplified aliphatic substituent and the exemplified aromatic substituent are bonded to a silicone element located in one repeat unit, but the polysiloxane is not limited thereto.

Further, the silicone-based foam precursor may include an addition-type silicone prepolymer such as a polysiloxane containing an aliphatic polysiloxane and an aromatic polysiloxane which each contain two or more vinyl groups, or a siloxane repeat unit containing both the aliphatic group and the aromatic group in one repeat unit or independently containing the aliphatic group and the aromatic group. As a specific example, 2 to 20 vinyl groups may be included in a single polysiloxane chain, but are not limited thereto, and as a molecular weight of the polysiloxane increases, the vinyl group may proportionally increase to more than 20, and polysiloxane having a low molecular weight may include 2 to 4 hydroxyl groups. As a specific non-limiting example, the aliphatic polysiloxane may be selected from the group consisting of polydimethylsiloxane, polydiethylsiloxane, polymethylethylsiloxane, polydimethylsiloxane-co-diethylsiloxane, and polydimethylsiloxane-co-ethylmethylsiloxane which each contain two or more vinyl groups, and the aromatic polysalic acid may be selected from the group consisting of polydiphenylsiloxane, polymethylphenylsiloxane, polyethylphenylsiloxane, and poly(dimethylsiloxane-co-diphenylsiloxane) which each contain two or more vinyl groups. The polysiloxane containing a siloxane repeat unit containing both the aliphatic group and the aromatic group in one repeat unit or independently containing the aliphatic group and the aromatic group may include both a repeat unit of the exemplified aliphatic siloxane and a repeat unit of the aromatic siloxane or may refer to a form in which the exemplified aliphatic substituent and the exemplified aromatic substituent are bonded to a silicone element located in one repeat unit, but the polysiloxane is not limited thereto. At this point, the condensation type silicone prepolymer may undergo crosslinking and curing by hydrolysis and condensation reaction in the presence of water, and the addition type silicone prepolymer may undergo crosslinking and curing by an addition reaction between the unsaturated group of the silicone-based prepolymer and the crosslinking agent in the presence of the catalyst.

In addition to the aforementioned, the silicone-based foam precursor may further include a crosslinking agent, a catalyst, or a mixture thereof, and the crosslinking agent, the catalyst, or the mixture may be used without particular limitation as long as it is commonly used in the art.

For example, when the silicone-based foam precursor contains a condensation type silicone-based prepolymer, the crosslinking agent may be a siloxane-based curing agent containing a Si-O bond, an organosilazane curing agent containing a Si-N bond, or the like, and as a non-limiting example, the crosslinking agent may be $(CH_3)Si(X)_3$ or $Si(OR)_4$. In this case, X may be methoxy, acetoxy, oxime, and an amine group, and R may have a lower alkyl group and, as a non-limiting example, R may be methyl, ethyl, or a propyl group. The catalyst is not limited as long as it is commonly used in the art, and as a non-limiting example, an organic tin compound, an organic titanium compound, or an amine-based compound may be used.

Alternatively, when the silicone-based foam precursor contains the addition type silicone prepolymer, the crosslinking agent may be used without limitation as long as it is any siloxane-based compound containing a Si-H bond, and as a non-limiting example, the crosslinking agent may be an aliphatic or aromatic polysiloxane containing a -(RaHSiO)-group. Ra may be the aliphatic group or the aromatic group, the aliphatic group may be a methyl group, an ethyl group, or a propyl group, the aromatic group may be a phenyl group or a naphthyl group, and the substituent may be substituted with another substituent or may be unsubstituted within a range not affecting the crosslinking reaction, but the aforementioned is only one example and the number of carbon atoms and a kind of substituent are not limited. As a non-limiting example, there may be polymethylhydrogensiloxane$[(CH_3)_3SiO(CH_3HSiO)xSi(CH_3)_3]$, polydimethylsiloxane$[(CH_3)_2HSiO((CH_3)_2SiO)xSi(CH_3)_2H]$, polyphenylhydrogensiloxane$[(CH_3)_3SiO(PhHSiO)xSi(CH_3)_3]$, or poly-diphenylsiloxane$[(CH_3)_2HSiO((Ph)_2SiO)xSi(CH_3)_2H]$, and in this case, a content of Si-H is preferably controlled according to the number of vinyl groups contained in the addition type silicone prepolymer, and for example, x may be in a range of 1 or more, more preferably in a range of 2 to 10, but is not limited thereto.

In this case, the catalyst may selectively be added to accelerate the reaction and is not limited as long as it is commonly used in the art, and as a non-limiting specific example, a platinum compound or the like may be used.

The polyolefin-based foam may be manufactured from a polyolefin-based foam precursor, and the polyolefin-based foam precursor may contain a polyolefin-based prepolymer. The polyolefin-based prepolymer may be crosslinked and cured by the crosslinking agent to form a polymer, and as a non-limiting example, the polymer may be poly(ethylene-co-alpha-olefin), ethylene propylene diene monomer rubber (EPDM rubber), polyisoprene, or polybutadiene, but is not limited thereto. In this case, the crosslinking agent may be a vulcanizing agent, and the vulcanizing agent is not limited as long as it is commonly used in the art, and as a non-limiting example, sulfur or organic peroxide may be used.

The polyurethane-based foam may be used as the foam to significantly lower the thermal conductivity. In this case, there is an advantage in that adhesive strength between a foam and an electrode and between the foam and a thermoelectric material is high and thus a glass frit, which is necessarily added to the electrode or the thermoelectric material so as to improve adhesive strength, can be excluded. As described above, since the glass frit having low electrical conductivity may be excluded from the electrode or the thermoelectric material, the efficiency of the thermoelectric power generation of the flexible thermoelectric device can further be improved, and also since the electrode or the thermoelectric material can be formed without using a paste, a manufacturing process of the flexible thermoelectric device can be significantly simplified.

That is, when the polyurethane-based foam is used as the filling material, adhesion between the filling material and the electrode and between the electrode and the thermoelectric material is significantly increased, so that desired adhesion may be secured without using the glass frit. However, the present invention does not completely exclude the glass frit, and even if the glass frit is excluded, sufficient adhesive strength may be secured, but when higher adhesive strength is required, the glass frit may be included in the electrode or the thermoelectric material.

More preferably, the polyurethane-based foam according to one embodiment of the present invention may be a polyisocyanate-based compound and be manufactured from the urethane-based foam precursor containing the aromatic polyisocyanate. Accordingly, the filling material may have significantly high thermal conductivity of 0.05 W/m.K or less while securing high adhesive strength, high flexibility, and high mechanical stability. Specifically, the aromatic polyisocyanate may be 4,4'-diphenylmethane diisocyanate (MDI) or 2,4-diphenylmethane diisocyanate.

Moreover, as described above, each foam composition according to one embodiment of the present invention may further include a crosslinking agent and a catalyst, which are used for curing of the prepolymer.

Contents of the prepolymer, the crosslinking agent, and the catalyst may be selected in consideration to a degree of curing of a pre-designed foam. Specifically, the content of the crosslinking agent may be in the range of 1 to 100 parts by weight based on 100 parts by weight of the prepolymer, preferably in the range of 3 to 50 parts by weight, and more preferably in the range of 5 to 20 parts by weight. The content of the catalyst may be in the range of 0.001 to 5 parts by weight based on 100 parts by weight of the prepolymer, preferably in the range of 0.1 to 1 part by weight. In the above-described ranges, a foam having high flexibility, high adhesive strength, and low thermal conductivity may be effectively formed such that the device may be implemented to have high stability even with frequent physical changes and thermal diffusion may be effectively prevented to significantly improve thermoelectric efficiency.

According to one embodiment of the present invention, it is preferable to control the type and content of the foaming agent according to a type of the precursor and required physical properties of the foam, but the foaming agent may not particularly be limited and may be used as long as it is conventionally used in the art. For example, when a material which will be foamed is the aforementioned prepolymer, the foaming agent may be selected from a hydrocarbon-type compound, a nitroso-type compound, an azo-type compound, an azide-type compound, an inorganic-based foaming agent, and water ($H_2O$). As an example of the foaming agent, the hydrocarbon-type compound may be n-butane, iso-butane, n-pentane, isopentane, or cyclopentane, the nitroso-type compound may be N,N'-dimethyl-N,N'-dinitrozoterephthalate imide or dinitroso penta methylenetetramine, the azo-type compound may be azodicarbonamide, diazoaminoazobenzene, or azobis (isobutyronitrile), the azide-type compound may be p,p'-oxy-bis (benzenesulfonyl salicylhydrazide), toluenesulfonyl semicarbazide, p,p'-oxy-bis (benzenesulfonylhydrazide), p,p'-diphenylbis (sulfonyl hydrazide), toluenesulfonylhydrazide, benzenesulfonyl hydrazide, or m-benzene-bis (sulfonium hydrazide), the inorganic foaming agent may be sodium hydrogen carbonate, ammonium carbonate, nitric acid ammonium, or ammonium chloride, but the present invention is not limited thereto.

As an example, when a polyurethane-based foam is formed as the filling material, the foaming agent may be water, and thus an isocyanate group (-NCO) reacts with water and a carbon dioxide gas may be discharged to form the polyurethane-based foam having significantly low thermal conductivity.

Alternatively, the foaming agent may perform a function of curing the prepolymer by application of external energy such as heat or light and simultaneously perform a function of foaming. For example, when the prepolymer contains the vinyl group which may be cured by a radical, the foaming agent may contain a thiol group or a radical generating substituent, which may react with the vinyl group to induce curing, and a gas may be generated due to reassembly, deformation, or decomposition of molecules of the foaming agent according to the application of the external energy. As a specific example, the azo-type compound is heated and decomposed to generate a radical, and at the same time, the nitrogen gas is generated such that the prepolymer is simultaneously foamed and cured to form the foam.

The foaming agent according to one embodiment is preferably added in an amount with which the prepolymer may be sufficiently foamed to become the foam, and as a specific example, the foaming agent may be used in the range of 0.1 to 20 parts by weight based on 100 parts by weight of the prepolymer, preferably in the range of 1 to 10 parts by weight. When the content of the foaming agent is too small, the foam may not be sufficiently formed, and when the amount of the foaming agent is too large, the foaming may excessively occur, and thus mechanical strength may be weakened, or the thermoelectric device may be damaged.

In addition, other than the above-mentioned additives, the foam composition may further include any one or two or more selected from a surfactant, a filler and a pigment according to targeted characteristics of a foam to be formed.

In one embodiment of the present invention, surface-modified aerosol silica, a surface-modified quartz powder, a surface-modified calcium carbonate powder, or a surface-modified diatomaceous earth powder may be used as the filler. As a specific non-limiting example, the filler may be surface-modified with the vinyl group, the Si-H group, or the hydroxyl group through a coupling agent. Through such a functional group, the filler may stably be bonded to a foam network, and fracture toughness of the foam may be improved. A content of the filler is preferably controlled within a range without degrading flexibility and adhesive strength of the foam, and as a specific example, the filler may be added in the range of 0.01 to 5 parts by weight based on 100 parts by weight of the prepolymer but is not limited thereto.

Accordingly, the foam may have porosity as high as possible in terms of thermal conductivity degradation, but the foam may be controlled to have mechanical strength of a certain level or more. As a specific example, the porosity (apparent porosity) of the foam may be in the range of 50 to 98% by volume, preferably in the range of 70 to 90% by volume. In the above-described ranges, thermal diffusion may be effectively prevented to significantly increase the thermoelectric efficiency, and sufficient mechanical strength may be provided to improve the lifetime and reliability of the thermoelectric device.

In one embodiment of the present invention, the foam is preferably kept flexible in a wide temperature range in consideration of an environment in which the thermoelectric device operates, and thus it is preferable to control a glass transition temperature Tg of the foam. For example, the glass transition temperature of the foam may be in the range of 150 to 0 °C, and preferably, a maximum temperature of the glass transition temperature may be 20 °C or less in terms of maintaining flexibility and adhesive strength with the electrode.

Further, in one embodiment of the present invention, the foam preferably maintains flexibility and mechanical

properties even under an environment where high physical deformation is applied, and thus it is preferable to control a shore A and tensile strength of the foam. As a specific example, hardness of the foam may be in the range of 10 to 40, preferably in the range of 20 to 35 so as to have higher flexibility. Further, as a specific example, tensile strength may be in the range of 30 to 300 kg/cm$^2$, preferably in the range of 40 to 90 kg/cm$^2$.

In addition, in one exemplary embodiment of the present invention, the foam composition may have a proper contact angle to be more effectively injected into empty spaces in the array of thermoelectric material legs. To enhance the adhesive strength between the filling material and the electrode, the foam composition which forms the filling material by curing may be sufficiently wetted in the electrode. Since, among the thermoelectric material and the electrode, the electrode has a large contact area with the filling material, the contact angle between the electrode and the foam precursor may be more significant. In other words, to fill empty spaces in the array of thermoelectric material legs with the foam composition, the foam composition may be sufficiently wetted in the thermoelectric material and the electrode, particularly, the electrode, and if the foam composition is not sufficiently wetted, empty spaces in the array of thermoelectric material legs may not fully filled with the foam composition. The contact angle between the electrode and the foam composition may be a contact angle defined by an interfacial tension equilibrium by three types of interfacial energy generated at an electrode-droplet interface, an electrode-gas phase interface and a droplet-gas phase interface when a foam composition droplet is dropped onto an upper surface of the flat plate (or film)-type electrode. In one embodiment, the contact angle between the foam composition and the electrode may be less than 90°, and preferably 0 to 60°.

Meanwhile, the electrode according to one embodiment of the present invention is not particularly limited as long as it is commonly used in the art, and the electrode may be formed using a conductive metal film or an electrode paste, and a concrete manufacturing method thereof will be described in detail in a method of manufacturing the thermoelectric material, which will be described below.

Further, in one embodiment of the present invention, the P-type thermoelectric material and the N-type thermoelectric material of the array of thermoelectric material legs may be formed by a conventional method and may be formed using a single crystal or a polycrystalline bulk thermoelectric material, and a concrete formation method thereof will be described in detail in a method of manufacturing a flexible thermoelectric material, which will be described below.

FIG. 2 is a cross-sectional view of a flexible thermoelectric device according to one embodiment of the present invention.

More specifically, as shown in FIG. 2, a flexible thermoelectric device 1200 according to one embodiment of the present invention includes an array of thermoelectric material legs disposed and spaced apart from each other and having at least one N-type thermoelectric material 1240 and at least one P-type thermoelectric material 1230; a first electrode 1220 and a second electrode 1220' configured to electrically connect thermoelectric materials of the array of thermoelectric material legs; and a foam 1250 configured to fill in at least one void of the array of thermoelectric material legs.

According to one embodiment of the present invention, the array of thermoelectric material legs may thermally be connected in parallel and electrically be connected in series and/or in parallel through the electrodes and the array of thermoelectric material legs in the flexible thermoelectric device.

As a specific example, the flexible thermoelectric device 1200 may thermally be connected in parallel and electrically be connected in series through the first electrode 1220, the second electrode 1220', and the array of thermoelectric material legs as shown in FIG. 2. Notably, as a specific example, one end of the N-type thermoelectric material 1240 may be connected to one end of one surface of the first electrode 1220, and one end of one surface of the second electrode 1220' may be connected to the other end of the N-type thermoelectric material 1240. Continuously, one end of the P-type thermoelectric material 1230 may be connected to the other end of one surface of the first electrode 1220, the other end of the P-type thermoelectric material 1230 may be connected to one end of one surface of another first electrode 1220 spaced apart from the first electrode 1220, and the flexible thermoelectric device 1200 may be configured by having a repeat unit as the aforementioned connection configuration.

In one embodiment of the present invention, a size and a shape of each of the N-type thermoelectric material and the P-type thermoelectric material may be appropriately designed in consideration of the use of the thermoelectric device so long as flexibility of the flexible thermoelectric device is not degraded. As a specific example, the N-type and P-type thermoelectric materials may have the same shape and size or different shapes and sizes from each other. More specifically, the N-type and P-type thermoelectric materials may independently be in the form of a plate or a leg, and each of the N-type and P-type thermoelectric materials may have a cross section in a shape with a curved line such as a circle or an ellipse or an angular shape in a thickness or length direction. In order not to degrade the flexibility of the flexible thermoelectric device, a thickness of the N-type or P-type thermoelectric material may have a thickness in the range of several tens of nanometers to tens of millimeters. Further, a cross-sectional area of an N-type or P-type thermoelectric leg may have an area in the range of hundreds of square nanometers to several square centimeters. As a practical example, the N-type or P-type thermoelectric material may have a thickness in the range of 100 nm to 5 cm, and the cross-sectional area of the thermoelectric material leg may be in the range of 0.1 $\mu m^2$ to 10 cm$^2$, but the present invention is not limited by a physical shape or size of the thermoelectric material. As described above, since the thermoelectric material may be manufactured with a thickness in the order of nanometer, the flexible thermoelectric device according to one embodiment of the present invention may also be manufactured with the thickness in the order of nanometer, and miniaturization and integration of the flexible thermoelectric device are possible. Further, since the flexible thermoelectric device may be manufactured such that the cross-sectional area of the thermoelectric material leg is formed in the order of $\mu m^2$ or less, it is possible to integrate a very large number of thermoelectric material columns within a given overall device area, such that it is advantageous for raising an overall output voltage.

Hereinafter, a method of manufacturing a flexible thermoelectric device, and specific materials for forming an electrode and a thermoelectric material according to the present invention will be described. Here, the foam composition used in a foaming operation uses the same material as described above, and therefore repeated descriptions will be omitted.

The method of manufacturing a flexible thermoelectric device according to the present invention may include forming a foam by foaming a foam composition. As described above, as the foam is formed by foaming the foam composition with a suitable range of viscosity by mixing an ortho-phthalate-based compound represented by Formula 1, empty spaces in the array of thermoelectric material legs may be easily filled with the foam composition, and the foam composition may be fully injected into the empty spaces, thereby ensuring complete adhesion between an electrode and the foam and between the thermoelectric material and the foam after the formation of the foam, and thus adhesive strength can be enhanced. FIG. 6 is a schematic flowchart of a method of manufacturing a flexible thermoelectric device according to one embodiment of the present invention.

In addition, since an amount of a foam precursor among compositions injected into empty spaces in the array of thermoelectric material legs by mixing an ortho-phthalate-based compound in the foam composition may be controlled in a suitable range, a volume change caused by foaming of the composition into a foam may be controlled to a suitable level, thereby preventing the damage to a thermoelectric device.

Specifically, a method (I) of manufacturing a flexible thermoelectric device according to one embodiment of the present invention may include a) forming a first structure in which a first sacrificial substrate, a first contact thermal conduction layer, a first electrode, and a P-type thermoelectric material formed at a predetermined region on the first electrode are sequentially stacked, and a second structure in which a second sacrificial substrate, a second contact thermal conduction layer, a second electrode, and an N-type thermoelectric material formed at a predetermined region on the second electrode are sequentially stacked, b) manufacturing a substrate having an array of thermoelectric material legs formed by physically connecting the first structure and the second structure, c) filling a foam composition and forming a foam in a void between the array of thermoelectric material legs of the substrate, and d) removing the first sacrificial substrate and the second sacrificial substrate.

First, the forming of the first structure according to the operation a) includes a-1) forming the first contact thermal conduction layer on the first sacrificial substrate, a-2) forming the first electrode on the first contact thermal conduction layer, and a-3) forming the P-type thermoelectric material at a predetermined region on the first electrode. The forming of the second structure is performed in the same manner as the forming of the first structure except for forming the N-type thermoelectric material at a predetermined region on the second electrode, and thus a repetitive description will be omitted.

In the operation a-1) according to one embodiment, the first sacrificial substrate serves as a support for maintaining a shape of the flexible thermoelectric device until the manufacturing of the flexible thermoelectric device is completed, and the first sacrificial substrate may further include a sacrificial film according to a characteristic of adhesive strength between the first sacrificial substrate and the first contact thermal conduction layer. That is, when the adhesive strength between the first sacrificial substrate and the first contact thermal conduction layer is low, the sacrificial film is not required, and when the adhesive strength therebetween is high, the first sacrificial substrate may further include the sacrificial film. Specifically, the sacrificial film may be used without particular limitation when the sacrificial film is a metal thin film or a polymer layer which has poor adhesive strength to the first sacrificial substrate, and as a specific example, the metal thin film may be a nickel thin film and the polymer layer may be formed by applying a polymer adhesive on the substrate, and as a specific example, the polymer adhesive may be a mixture or compound composed of one or more selected from a glue, a starch, acetyl cellulose, polyvinyl acetate, epoxy, urethane, chloroprene rubber, nitrile rubber, a phenol resin, a silicate-based resin, an alumina cement, a urea resin, a melamine resin, an acrylic resin, a polyester resin, a vinyl/phenol resin, and an epoxy/phenolic resin. In this case, any method known in the art may be used as a method for forming a sacrificial film as long as it is capable of forming a metal thin film on a substrate. As a specific example, the sacrificial film may be formed by spin coating, a screen printing technique, sputtering, thermal evaporation, chemical vapor deposition, electrodeposition, or spray coating.

Any type of a material may be used as the first sacrificial substrate without limitation as long as it has poor adhesive strength to the first contact thermal conduction layer or the sacrificial film, and a material, a shape, a size, and the like of a substrate are not limited. As a specific example, the first sacrificial substrate may employ any one selected from among silicone, silicone oxide, sapphire, alumina, mica, germanium, silicone carbide, gold, silver, and a polymer.

The first contact thermal conduction layer is used to form a thermal conduction layer capable of minimizing a

heat loss of the flexible thermoelectric device, and the first contact thermal conduction layer may preferably be formed of a material having high thermal conductivity, and as a specific example, aluminum nitride (AlN), silicone nitride ($Si_3N_4$), alumina ($Al_2O_3$), or the like may be used but the present invention is not limited thereto. Any known method may be used as a method of forming a first contact thermal conductor as long as it is capable of forming a first contact thermal conductor thin film on the substrate. As a specific example, the sacrificial film may be formed by spin coating, a screen printing technique, sputtering, thermal evaporation, chemical vapor deposition, electrodeposition, or spray coating.

The operation a-2) according to one embodiment is an operation of forming the first electrode, and any method may be used as long as it is capable of forming the first electrode according to a designed pattern, and for example, the first electrode may be formed using a conductive metal film or a paste for an electrode. When an electrode paste is used to form an electrode, the electrode may be formed by screen printing, sputtering, evaporation, chemical vapor deposition, pattern transfer, electrodeposition, or the like.

As an example of the electrode, when the conductive metal film is used as the electrode, the conductive metal film may be selected in consideration of a type, thermal conductivity, electrical conductivity, a thickness, and the like of a designed electrode. For example, the conductive metal film may be a transition metal film of Group 3 to Group 12, and as a specific example, a transition metal may be one or a mixture of two or more selected from nickel (Ni), copper (Cu), platinum (Pt), ruthenium (Ru), rhodium (Rh), gold (Au), tungsten (W), cobalt (Co), palladium (Pd), titanium (Ti), tantalum (Ta), iron (Fe), molybdenum (Mo), hafnium (Hf), iridium (Ir), and silver (Ag), and it is preferable to use a copper (Cu) film in terms of high electrical conductivity, adhesive strength to a filling material, and a low cost.

Further, when the electrode is formed using the electrode paste, the electrode paste may include a first conductive material, and specifically, may contain the first conductive material, a first solvent, and a first binder. For example, a composition and a content of each component of the electrode paste may be controlled in consideration of a type, thermal conductivity, electrical conductivity, thickness, and the like of a designed electrode. As a specific example, the electrode paste may include 10 to 90% of the first conductive material by weight, 5 to 50% of the first solvent by weight, and 2 to 10% of the first binder by weight among a total weight.

More specifically, a type of the first conductive material according to a non-limiting example is not particularly limited as long as it is a material having high thermal conductivity and electrical conductivity, and for example, a metal material or a carbon nanotube and a carbon nanowire that possess high electrical conductivity may be used. It is preferable to use a metal material which is high in thermal conductivity and electrical conduction characteristics and is high in binding strength to the filling material to improve physical strength of the thermoelectric device. For example, the metal material may be a transition metal film of Group 3 to Group 12, and specifically, a transition metal may be one or more selected from Ni, Cu, Pt, Ru, Rh, Au, W, Co, Pd, Ti, Ta, Fe, Mo, Hf, Ir, and Ag, and it is preferable to use a Cu film in terms of high electrical conductivity, binding strength to the filling material, and a low cost. The first solvent is used to control fluidity of the paste for an electrode and is not particularly limited as long as it is capable of dissolving the first binder, and as a specific example, an alcohol-based solvent, a ketone-based solvent, or a mixed solvent thereof may be used. The first binder is used to control printing resolution, and as a specific example, a resin-based material may be used.

Further, in one embodiment of the present invention, when high adhesive strength between the electrode and the filling material is required, a glass frit may further be added to the paste for an electrode in order to manufacture the electrode.

In one embodiment of the present invention, a relative content of the glass frit with respect to the first conductive material may be controlled in consideration of improvement in adhesive strength and degradation in electrical conductivity due to the glass frit. As a specific example, the electrode may contain the glass frit in the range of 0.1 to 20 parts by weight based on 100 parts of the first conductive material by weight. At this point, in order to improve the flexibility of the thermoelectric device, it is preferable to implement the electrode as thinly as possible. However, as the thickness of the electrode becomes thinner, degradation in electrical conductivity may occur due to the glass frit. Accordingly, the relative content of the glass frit with respect to the first conductive material is preferably within a minimum content range in which an improving effect of the adhesive strength may be exhibited. In this regard, the electrode may contain the glass frit in the range of 0.5 to 10 parts by weight, specifically in the range of 1 to 5 parts by weight based on 100 parts of the first conductive material by weight.

However, as described above, since the thermoelectric device according to the present invention may have high adhesive strength between the electrode and the filling material when using the foam as the filling material, it is not necessary to add the glass frit, and thus the electrode may be manufactured through a very simplified process using the conductive metal film and the glass frit may not be added to the electrode, such that thermal conductivity and the electrical conductivity of the electrode are improved and there is an advantage in that thermoelectric efficiency of the thermoelectric device may be improved.

The operation a-3) according to one embodiment is an operation of forming the thermoelectric material, and specifically, an operation of forming the P-type thermoelectric material at a predetermined region on the patterned first electrode. Any method may be used as the operation a-3) as long as it is capable of forming the P-type thermoelectric

material at a predetermined region on the first electrode as designed, and for example, the P-type thermoelectric material may be formed using a single crystal, a polycrystalline bulk material, or a paste for a thermoelectric material. Specifically, the single crystal may be used as the thermoelectric material because the flexible thermoelectric device according to one embodiment of the present invention does not need to provide a flexible mesh through improvement in adhesive strength between the electrode and the filling material.

However, as shown in FIG. 2, when the first structure and the second structure are connected to each other, the P-type thermoelectric material formed at the first electrode and the N-type thermoelectric material formed at the second electrode should be formed and spaced apart from each other so as to be electrically connected by the electrode as designed in advance.

As a specific example, when the P-type thermoelectric material is formed of a bulk material, an antimony-tellurium-based compound (SbxTe1-x) or a bismuth-antimony-tellurium-based compound ($BiySb_2$-$yTe_3$) (x is $0 < x \leq 1$ and y is $0 \leq y \leq 2$) may be formed in a designed shape through a process such as cutting or the like to have a suitable shape, and then the P-type thermoelectric material may be adhered to the upper portion of the first electrode in a designed pattern using a conductive adhesive. In this case, the conductive adhesive may be a silver paste containing silver, and as a specific example, a silver (Ag) paste, a tin-silver (Sn-Ag) paste, a tin-silver-copper (Sn-Ag-Cu) paste, or a tin-antimony (Sn-Sb) paste may be used, but the present invention is not limited thereto.

Alternatively, when the P-type thermoelectric material is formed in a thick film form using a thermoelectric material paste, the P-type thermoelectric material may be formed through screen printing, and specifically, the P-type thermoelectric material may be applied on the upper portion of the first electrode as a designed pattern and then may undergo heat treatment to form the thermoelectric material.

The P-type thermoelectric material paste may include a second conductive material, and more specifically, may contain the second conductive material, a second solvent, and a second binder. For example, a composition and a content of each component of the P-type thermoelectric material paste may be controlled in consideration of a type, thermal conductivity, electrical conductivity, thickness, and the like of a designed thermoelectric material.

Preferably, the second conductive material uses an antimony-tellurium-based (SbxTe1-x) compound or a bismuth-antimony-tellurium-based ($BiySb_2$-$yTe_3$) compound (x is $0 \leq x \leq 1$ and y is $0 \leq y \leq 2$). The second solvent is used to control fluidity of the P-type thermoelectric material paste and is not particularly limited as long as it is capable of dissolving the second binder. As a specific example, an alcohol-based solvent, a ketone-based solvent, or a mixed solvent thereof may be used. The second binder is used to control printing resolution, and as a specific example, a resin-based material may be used.

It may be preferable that contents of constituent components of the P-type thermoelectric material paste are controlled so as to allow the thermoelectric material leg array to have a thermoelectric performance index ZT of 0.1 K-1 or more. As a specific example, the P-type thermoelectric material paste may include 10 to 90% of the second conductive material by weight, 5 to 50% of the second solvent by weight, and 2 to 10% of the second binder by weight based on a total weight.

In the operation a-3) according to one embodiment, the P-type thermoelectric material paste may be applied on the upper portion of the first electrode as a designed pattern and then may undergo heat treatment to form the P-type thermoelectric material. A heat treatment may be performed through a method which is commonly used in the art, and as a specific example, annealing may be performed at a temperature in the range of 300 to 1000 °C for 30 to 200 minutes to form the P-type thermoelectric material, and preferably, the annealing may be performed at a temperature in the range of 400 to 600 °C for 60 to 120 minutes.

Meanwhile, the second structure may be formed such that the second electrode is formed through the same method as in the first structure and then the N-type thermoelectric material may be formed at a predetermined region on the second electrode. In this case, the N type thermoelectric material may use a bulk material, or an N type thermoelectric material paste.

As a specific example, when the N-type thermoelectric material is formed of a bulk material, a bismuth-tellurium-based compound (BixTe1-x) or a bismuth-tellurium-selenium-based compound ($Bi_2Te_3$-$yTe_3$) (x is $0 \leq x \leq 1$ and y is $0 \leq y \leq 2$) may be formed in a designed shape through a process such as cutting or the like to have a suitable shape, and then the N-type thermoelectric material may be adhered to the upper portion of the second electrode in a designed pattern using a conductive adhesive. In this case, the conductive adhesive may be a silver paste containing silver, and as a specific example, an Ag paste, a Sn-Ag paste, a Sn-Ag-Cu paste, or a Sn-Sb paste may be used, but the present invention is not limited thereto.

Alternatively, when the N-type thermoelectric material is formed in a thick film form using a thermoelectric material paste, the N-type thermoelectric material may be formed through screen printing, and specifically, the N-type thermoelectric material may be applied on the upper portion of the second electrode as a designed pattern and then may undergo heat treatment to form the thermoelectric material. The N-type thermoelectric material paste may be the same as the P-type thermoelectric material paste except for the second conductive material. Specifically, the N-type thermoelectric material paste may preferably use a bismuth-tellurium-based (BixTe1-x) compound or a bismuth-tellonium-

selenium ($Bi_2Te_3$-ySey) compound (x is $0 \leq x \leq 1$ and y is $0 \leq y \leq 2$) as the second conductive material.

In this case, in the P type or the N type thermoelectric material, when a thermoelectric material contains tellurium (Te), in order to prevent evaporation of tellurium (Te) during heat treatment at a high temperature, the heat treatment may be performed by inserting a tellurium (Te) powder into a heat treatment oven or a heat treatment furnace.

Next, the operation b) manufacturing the substrate having an array of thermoelectric material legs formed by physically connecting the first structure and the second structure may be performed. As described above, the first structure and the second structure may be connected to separate the thermoelectric materials from each other, and as shown in FIG. 2, the first and second structures may be connected to alternately dispose the P-type thermoelectric material and the N-type thermoelectric material. For example, the above-described connection may be performed through bonding, and bonding is not particularly limited as long as it is capable of bonding the electrode and the thermoelectric material, and for example, bonding may be performed using a conductive adhesive. For example, the conductive adhesive may be a silver paste containing silver, and as a specific example, a silver (Ag) paste, a tin-silver (Sn-Ag) paste, a tin-silver-copper (Sn-Ag-Cu) paste, or a tin-antimony (Sn-Sb) paste may be used, but the present invention is not limited thereto.

Subsequently, the operation c) of injecting the foam composition into empty spaces in the array of thermoelectric material legs of the substrate and forming a foam may be performed. In other words, according to the operation c), the thermoelectric material may be physically supported, and the mechanical properties of the thermoelectric device may be ensured. Specifically, the operation c) may include c-1) injecting the foam composition into empty spaces in the array of thermoelectric material legs of the substrate; and c-2) forming a foam by curing and foaming the foam composition. In addition, after the formation of a filling material, that is, a foam, the foam remaining in unnecessary regions, other than the empty spaces, may be removed.

The operation c-1) according to one embodiment is not limited as long as it is capable of filling the foam composition in a gap between the N-type thermoelectric material and the P-type thermoelectric material, and for example, a liquid phase foam composition may fill in the substrate on which the electrode and the thermoelectric material leg arrays are formed using a capillary phenomenon, or may fill in the substrate by dipping the substrate on which the electrode and the array of thermoelectric material legs are formed in a water tank filled with the liquid phase foam composition.

The operation c-2) according to one embodiment is an operation of curing and foaming the foam composition filling in the void formed by the array of thermoelectric material legs to form the foam, and at this point, the foam composition may contain a polymer, a prepolymer, or a foaming agent, and when the polymer or the prepolymer is in a liquid phase, drying may be omitted but when the polymer or the prepolymer is in a solution phase dissolved in a solvent, drying may be further performed before the curing and foaming. Drying according to one embodiment may be performed at a temperature at which the solvent may sufficiently be blown for a predetermined period of time. As a specific example, when the prepolymer is a urethane-based prepolymer, a drying temperature may be in the range of room temperature to 150 °C, and a drying time may be in the range of 1 minute to 24 hours. The curing and foaming operation may vary according to the types and contents of the polymer or prepolymer and the foaming agent, of course.

Next, the operation d) of removing the first sacrificial substrate and the second sacrificial substrate may be performed. In the operation d) according to one embodiment, when a sacrificial substrate on which a sacrificial film is not formed is used, the removing may be performed by peeling only the sacrificial substrate from the contact thermal conduction layer, and any method may be used without limitation as long as it is capable of peeling the sacrificial substrate from the contact thermal conduction layer, and for example, the sacrificial substrate may physically or chemically be peeled in air or water.

In the case of the sacrificial substrate having the sacrificial film formed thereon in an operation d) according to another embodiment, the removing of the sacrificial substrate may be performed by removing a substrate from the sacrificial substrate and then removing the sacrificial film. The removing method may be used without particular limitation as long as it is capable of peeling only the substrate from the sacrificial film, and for example, the substrate may physically or chemically be peeled in air or water. As a specific example, when a silicone oxide film substrate having a nickel film formed thereon is used as the sacrificial film, peeling occurs at an interface between the silicone oxide film substrate and the nickel film in the case that a pre-thermoelectric device having the filling material formed therein is immersed in a water bath for a predetermined period of time. The removing of the sacrificial film may be performed through etching, and the method of etching is not particularly limited, and the sacrificial film may be removed through wet etching and/or chemical physical polishing. Preferably, the sacrificial film may be removed through wet etching, and in this case, a composition of an etchant may be varied according to a type of a metal thin film of the sacrificial film.

A method (II) of manufacturing a flexible thermoelectric device according to one embodiment of the present invention may include A) forming a first-first structure in which a first-first sacrificial substrate, a first-first contact thermal conductor layer, a first electrode are sequentially stacked, and a second-first structure in which a second-first sacrificial substrate, a second-first contact thermal conductor layer, and a second-first electrode are sequentially stacked, B) forming a P-type thermoelectric material on a third-first sacrificial substrate and forming an N-type thermoelectric material

on a fourth-first sacrificial substrate, C) transferring each of the P-type thermoelectric material and the N-type thermoelectric material to the first-first structure, D) manufacturing a substrate on which an array of thermoelectric material legs are formed by physically connecting the second-first structure and the first-first structure to which the P-type thermoelectric material and the N-type thermoelectric material are transferred, E) filling a foam composition and forming a foam in a void between the array of thermoelectric material legs, and F) removing the first-first sacrificial substrate and the second-first sacrificial substrate.

In the method (II) of manufacturing a flexible thermoelectric device, except that the P-type thermoelectric material and the N-type thermoelectric material are transferred to the first-first structure and then the first-first structure is connected to the second-first structure, all operations may be the same as described in the method (I) of manufacturing a flexible thermoelectric device. That is, forming a contact thermal conductor on a sacrificial substrate, forming an electrode on the contact thermal conductor, forming a thermoelectric material (the forming is the same except that a lower base material is different, and the third-first sacrificial substrate and the fourth-first sacrificial substrate may be any one selected from the materials listed in the first sacrificial substrate and the third-first sacrificial substrate and the fourth-first sacrificial substrate may be the same or different from each other), forming a filling material, and removing a sacrificial substrate are the same as those described in the method (I) of manufacturing a flexible thermoelectric device, and thus detailed description thereof will be omitted.

The operation C) according to one embodiment may be an operation of transferring each of the P-type thermoelectric material and the N-type thermoelectric material to the first-first structure. Specifically, the P-type thermoelectric material and the N-type thermoelectric material formed at each of the third-first sacrificial substrate and the fourth-first sacrificial substrate may be transferred to the first-first structure. The transferring method may be used without particular limitation as long as it is commonly used in the art.

Next, the operation D) of manufacturing the substrate on which the array of thermoelectric material legsis formed by physically connecting the second-first structure and the first-first structure to which the P-type thermoelectric material and the N-type thermoelectric material are transferred may be performed. As described above, the second-first structure and the first-first structure to which the P-type thermoelectric material and the N-type thermoelectric material are transferred may be connected to space the thermoelectric materials from each other, and as shown in FIG. 2, the second-first structure and the first-first structure may be connected to alternately dispose the P-type thermoelectric material and the N-type thermoelectric material. For example, the above-described connection may be performed through bonding, and the bonding method is not particularly limited as long as it is capable of bonding the electrode and the thermoelectric material, and for example, bonding may be performed using a conductive adhesive. As an example, the conductive adhesive may be a silver paste containing silver, and as a specific example, a silver (Ag) paste, a tin-silver (Sn-Ag) paste, a tin-silver-copper (Sn-Ag-Cu) paste, or a tin-antimony (Sn-Sb) paste may be used, but the present invention is not limited thereto.

The flexible thermoelectric device according to one embodiment of the present invention can be applied to objects having various shapes. In one embodiment, the flexible thermoelectric device enables power generation using a body heat generated from a human body. As an example, thermoelectric power generation may be accomplished by applying the flexible thermoelectric device to an arms of a human body.

Also, the flexible thermoelectric device according to the present invention can be applied to a part in the presence of heat or where cooling is needed, such as an automobile, a ship, a windshield, a smart phone, an airplane, or a power plant. Generally, since objects have arbitrary shapes, the flexible thermoelectric device according to the present invention has an advantage in being capable of being applied to objects of various shapes. Further, since the flexible thermoelectric device may match a shape of an application portion and be in direct contact with the application portion, heat transfer efficiency may be improved and thus performance of the thermoelectric device may be maximized with respect to an applied object. Furthermore, since the flexible thermoelectric device may be manufactured using a thin insulating layer with high thermal conductivity, higher thermoelectric efficiency may be achieved in comparison to using a conventional alumina ($Al_2O_3$) substrate.

Meanwhile, in the flexible thermoelectric device according to one embodiment of the present invention, the foam cured after the empty spaces in the array of thermoelectric material legs are filled may impart flexibility to the flexible thermoelectric device due to its own flexibility, and support other components of the flexible thermoelectric device, such as the electrode and the array of thermoelectric material legs, without a substrate.

Generally, in the thermoelectric device, the electrode is supported on the substrate by fixing both ends of the electrode to the substrate disposed opposite to the electrode, and the array of thermoelectric material legs is supported on the substrate through electrodes by fixing the array of thermoelectric material legs between the electrodes. However, in this type of thermoelectric device, flexibility may not be imparted because it is difficult for the substrate to have flexibility.

In the flexible thermoelectric device according to one embodiment of the present invention, the function of supporting the electrodes and the array of thermoelectric material legs of the substrate is replaced by the foam, and therefore the substrate having an adverse effect on flexibility may be removed from the flexible thermoelectric device, resulting in optimization of flexibility of the flexible thermoelectric device.

Moreover, the foam may well support the electrodes and the thermoelectric material legs, and will be described in detail below.

First, referring to FIG. 2 again, the foam is provided as a uni-body. That is, the foam in the present invention may not be provided in the form of inserting several foams between the array of thermoelectric material legs only for insulation between the array of thermoelectric material legs, but provided in the form of sandwiching the array of thermoelectric material legs in a body which is a uni-body formed by curing.

Therefore, the array of thermoelectric material legs is adhered to the foam on the entire or most of the side surfaces thereof, and the foam may provide a sufficient supporting force to the array of thermoelectric material legs. Particularly, since the foam has excellent elasticity and flexibility, although the flexible thermoelectric device is bent once or repeatedly, the supporting force may be consistently provided to the electrode.

In addition, the foam may contact the electrode not only on the main surface of the electrode facing the array of thermoelectric material legs, but also on the side of the electrode, and since the foam provides a supporting force to the electrode by these surfaces, a more stable supporting force may be provided than that when the electrode is supported only by one surface. Particularly, since a type of groove is formed in the foam, and the electrode is inserted into the groove, the adhesion between the foam and the side surface of the electrode may provide a much higher supporting force than that when the electrode is supported by the foam only on the main surface of the electrode.

Therefore, in the flexible thermoelectric device according to the present invention, a height of the foam may be greater than that of the array of thermoelectric material legs. More preferably, the foam may be divided into a high region and a low region. Here, in the top view of the flexible thermoelectric device, the high region may be a region in which the electrode is not located, and the low region may be a region in which the electrode is located.

Here, the height of the high region may be substantially equal to the sum of the height of the array of thermoelectric material legs and twice the thickness of the electrode. In addition, the height of the low region may be substantially equal to the sum of the height of the array of thermoelectric material legs and the thickness of the electrode.

Looking at the entire body of this foam, a groove corresponding to the shape of the electrode is formed in the surface of the two main surfaces thereof, and the electrode may be inserted into the groove. In addition, in the top view of the flexible thermoelectric device, a through hole extending to the main surface of the foam, which is opposite to the main surface in which the groove is formed, is formed at both ends of the groove into which the electrode is inserted, and the array of thermoelectric material legs may be inserted into the through hole.

In addition, the height of the foam has a low region with a first height and a high region with a second height, except for a tolerance, in which the low region may be the region with a groove, and the low region may be the region without a groove. Further, the first height may be at least higher than the height of the array of thermoelectric material legs, and preferably equal to the sum of the height of the array of thermoelectric material legs and the thickness of the electrode. Moreover, the second height may be at least higher than the first height, and preferably equal to the sum of the height of the array of thermoelectric material legs and twice the height of the electrode.

The flexible thermoelectric device and a production method thereof according to the present invention will be described in more detail below with reference to the following examples. It should be understood, however, that the following examples are merely illustrative, and the present invention is not limited thereto, and the present invention may be implemented in various forms. Unless otherwise defined, all technical and scientific terms have the same meanings as commonly understood by one skilled in the art to which the present invention pertains. Terms used herein are merely intended to effectively describe a specific example and are not intended to limit the present invention. Further, the singular forms used in this disclosure and the appended claims are intended to include the plural forms, unless the context clearly indicates otherwise. Furthermore, a unit of an additive may be wt% unless specifically described in this disclosure.

[Characteristic Evaluation]

1) Thermal conductivity (W/m·K): this was calculated with specific heat × thermal diffusion coefficient × density.

Specific heat: an input difference of energy required for maintaining a temperature difference between a specimen and a reference material at zero was measured with a function of time and temperature by varying temperatures of the specimen and the reference material through a program (differential scanning calorimetry).

Thermal diffusivity: this was measured by detecting a temperature rise at a rear surface of the specimen according to time by an infrared detector (IR detector) while uniformly heating a front surface of the specimen using an instantaneous flash of a laser beam (Laser Flash method).

Density: this was measured by measuring a weight and an apparent volume of the specimen and dividing the weight by the apparent volume.

2) Thermoelectric performance index (ZT and K-1): this was measured by applying a square wave current to the

thermoelectric device and measuring a voltage generated from the thermoelectric material due to the applied current (according to the Harman method that is commonly used). ZTair is a thermoelectric performance index before filling the foam, and ZTfiller is a thermoelectric performance index after forming the foam.

$$\text{- ZT variation (\%)} = (\text{ZTair - ZTfiller}) / \text{ZTair} \times 100$$

3) Adhesive strength (MPa): an adhesive force of the interface being completely peeled off was measured while gradually applying a force to both ends based on the adhesive interface and pulling both of the ends (pull-off test).
4) Porosity (volume%): this was measured inside a material by comparing with a density of the specimen (as a porosity becomes higher, the density of the specimen becomes lower and the porosity may be calculated based on the specimen with a porosity of 0%).
5) Viscosity (cps): The viscosity of each solution was measured using a rotary viscometer and applied to a mixed solution viscosity calculation formula below, thereby deducing a viscosity of the total mixed solution.

Mixed Solution Viscosity Calculation Formula: log z = A log x + B log y
x, y : Viscosity of each solution before mixing (cps)
A, B : Mixing proportion of each solution, where A+B=1.
z : Viscosity of mixed solution

[Example 1]

The flexible thermoelectric device cannot maintain a shape thereof without a filler because the filler should be manufactured in the form of supporting a copper electrode and a thermoelectric material in the flexible thermoelectric device. Therefore, in order to determine a variation in thermoelectric performance index of the thermoelectric device according to change of the filler, the thermoelectric performance indexes before and after filling with the filler in a commercially available device with a substrate were measured and the variation was determined. The commercially available device used in this experiment is a SP1848-27145 model of Shenzhen Eshinede Technology Company of China. ZTair of the thermoelectric device was measured using the Haman method before filling with the filling material in the thermoelectric device, and a value of ZTair was 0.678 K-1.
Subsequently, to form a filling material, that is, a polyurethane foam, a mixture was prepared by measuring Flexfoam-iT X produced by Smooth-On, Inc. as a curing agent (part A) and a major material (part B) in a volume ratio of 1:1, and then a foam composition was prepared by mixing the mixture and butyl benzyl phthalate (n-butyl benzyl phthalate) in a volume ratio of 3 : 1.
The foam composition was poured into a mold containing a commercially-available thermoelectric device at room temperature to uniformly fill the thermoelectric device. After the filling operation for approximately 5 minutes, the urethane foam was dried in an oven at 60°C for 10 minutes, completely cured and foamed, and other regions, except the polyurethane foam filled in the thermoelectric device, were removed, thereby completing the inner filling of the commercially-available thermoelectric device. $ZT_{filler}$ of the thermoelectric device filled with the polyurethane foam was measured, and the value is 0.633 $K^{-1}$ which showed a 6.6% ZT variation with respect to that before the thermoelectric device was filled with the filler.

[Examples 2 to 5]

All operations were performed in the same manner as described in Example 1, except that a mixture was prepared by measuring Flexfoam-iT X produced by Smooth-On, Inc. as a curing agent (part A) and a major material (part B) in a volume ratio of 1:1, and then a foam composition was prepared by mixing the mixture and butyl benzyl phthalate in a volume ratio below.

Example 2: mixture : butyl benzyl phthalate = 1 : 0.2
Example 3: mixture : butyl benzyl phthalate = 1 : 0.3
Example 4: mixture : butyl benzyl phthalate = 1 : 0.4
Example 5: mixture : butyl benzyl phthalate = 1 : 0.5

[Example 6]

In the manufacturing of the flexible thermoelectric device using the polyurethane foam as the filling material,

the thermoelectric material was formed through screen printing and a thermoelectric performance index was determined by comparing with the results of Examples 1 and 7.

Two silicone oxide substrates (4-inch wafers), each of which has a Si layer formed as a sacrificial substrate were provided. Next, a copper film electrode having a thickness of about 30 μm was formed on each of the two substrates on which an aluminum nitride film was formed. Next, a P-type thermoelectric material or an N-type thermoelectric material was formed on an electrode of each of the two substrates on which the electrode is formed (hereinafter, for convenience of description, the electrode in which the P-type thermoelectric material is formed is referred to as a first electrode, and the electrode in which the N-type thermoelectric material is formed is referred to as a second electrode).

Specifically, a P-type thermoelectric material paste was applied to a predetermined region of the first electrode through screen printing and underwent heat treatment to form the P-type thermoelectric material. At this point, the P-type thermoelectric material paste was prepared by mixing 84.5 wt% $Bi0._3Sb_{1.7}Te_3$ powder, 12.8 wt% (binder + solvent) (7SVB-45), and 2.7 wt% glass frit ($Bi_2O_3$, $Al_2O_3$, $SiO_3$, and ZnO), and in the case of heat treatment, the solvent was removed after 10 minutes at a temperature of 100 °C, heat treatment was performed at a temperature of 250 °C for 30 minutes to remove the binder, and annealing was performed at a temperature of 550 °C for 80 minutes.

An N-type thermoelectric material paste was applied to a predetermined region of the second electrode through screen printing and underwent heat treatment to form the N-type thermoelectric material. At this point, the N-type thermoelectric material paste was manufactured by mixing 84.5 wt% BixTe1-x powder, 12.8 wt% (binder + solvent) (7SVB-45), and 2.7 wt% glass frit ($Bi_2O_3$, $Al_2O_3$, $SiO_3$, and ZnO), and in the case of heat treatment, the solvent was removed after 10 minutes at a temperature of 100 °C, heat treatment was performed at a temperature of 250 °C for 30 minutes to remove the binder, and annealing was performed at a temperature of 510 °C for 90 minutes. Next, as shown in FIG. 2, the substrate on which the P-type thermoelectric material was formed and the substrate on which the N-type thermoelectric material was formed were bonded using a silver paste to manufacture a substrate having thermoelectric material leg arrays.

Subsequently, to form a polyurethane foam as a filling material, a mixture was prepared by measuring Flexfoam-iT X produced by Smooth-On, Inc. as a major material (part A) and a curing agent (part B) in a volume ratio of 1:1, and then a foam composition was prepared by mixing the mixture and butyl benzyl phthalate in a volume ratio of 3 : 1. The foam composition was poured into a mold containing a flexible thermoelectric device at room temperature to uniformly fill the thermoelectric device, and foamed and cured. After the filling operation for approximately 5 minutes, the urethane foam was dried in an oven at 60 °C for 10 minutes, completely cured, and other regions, except the polyurethane foam filled in the thermoelectric device, were removed, thereby manufacturing a flexible thermoelectric device.

Finally, the silicone thin film formed on the substrate was peeled off using laser delamination, and the $Si/SiO_2$ layer remaining outside the flexible thermoelectric device was removed with a mixed solution of $HNO_3$, $H_2O$, and HF (10 volume%: 75 volume%: 15 volume% respectively) to manufacture the flexible thermoelectric device.

Since an internal filler material of the manufactured flexible thermoelectric device had very low thermal conductivity, as a flexible thermoelectric device manufactured by a screen-printing process, excellent thermoelectric efficiency was exhibited, and very excellent adhesive strength between the polyurethane foam and the electrode and mechanical stability were exhibited.

[Example 7]

A flexible thermoelectric device was manufactured using a bulk thermoelectric material and a polyurethane foam which were commercially available in the market as a filling material, and Whether similar thermoelectric performance characteristics were exhibited in a flexible thermoelectric device structure was determined by comparing the results to the results of Examples 1 and 2.

A first electrode and a second electrode were formed through the same method as in Example 6, a P-type bulky thermoelectric material and an N-type bulky thermoelectric material were respectively bonded to the first electrode and the second electrode using a silver paste as a designed pattern, a substrate on which the P-type thermoelectric material was formed and a substrate on which the N-type thermoelectric material was formed were bonded to each other to manufacture a substrate having thermoelectric material leg arrays formed therein.

For formation and filling of the polyurethane foam, a mixture was prepared by measuring Flexfoam-iT X produced by Smooth-On, Inc. as a major material (part A) and a curing agent (part B) in a volume ratio of 1:1, and then a foam composition was prepared by mixing the mixture and butyl benzyl phthalate in a volume ratio of 3 : 1. The foam composition was poured into a mold containing a flexible thermoelectric device at room temperature to uniformly fill the thermoelectric device. After the filling operation for approximately 5 minutes, the urethane foam was dried in an oven for 10 minutes and completely cured, and other regions, except the polyurethane foam filled in the thermoelectric device, were removed, thereby manufacturing a flexible thermoelectric device. The substrate supporting the device before the device is filled with the filler material was removed by a physical method, thereby completing the device.

[Comparative Examples 1 to 3]

All processes were performed in the same manner as described in Example 1, except that a mixture was prepared by measuring Flexfoam-iT X produced by Smooth-On, Inc. as a curing agent (part A) and a major material (part B) in a volume ratio of 1:1, and then a foam composition was prepared by mixing the mixture and butyl benzyl phthalate in a volume ratio below.

Comparative Example 1: mixture : butyl benzyl phthalate = 1 : 0
Comparative Example 2: mixture : butyl benzyl phthalate = 1 : 0.05
Comparative Example 3: mixture : butyl benzyl phthalate : = 1 : 1

As a result, in Comparative Examples 1 and 2, the viscosity of the foam composition was too high to be fully injected into the thermoelectric device, and the polyurethane foam was formed before empty spaces in the array of thermoelectric material legs were fully filled with the foam composition after foaming started approximately 40 seconds after the preparation of the foam composition, and therefore the thermoelectric device was not properly manufactured. In Comparative Example 3, as the polyurethane foam was not properly formed and decreased in mechanical strength, the polyurethane foam was easily torn, and thus the device was damaged.

[Comparative Examples 4 and 5]

All processes were performed in the same manner as described in Example 1, except that polyethylene glycol was used instead of butyl benzyl phthalate.

Comparative Example 4 : $C_4H_{10}O_3$
Comparative Example 5: $C_{14}H_{30}O_8$

Due to low adhesive strength between the filling material and the electrode, when being used for a long time, the thermoelectric device was damaged by separation of the filling material from the electrode.

[Comparative Example 6]

A commercially available thermoelectric device was used the same as in Example 1, and a characteristic of the commercially available thermoelectric device was evaluated by changing the filling material to urethane-based rubber. At this time, to form urethane-based rubber as a filling material, a mixture was prepared by measuring Vytaflex30 produced by Smooth-On, Inc. as a major material (part A) and a curing agent (part B) in a volume ratio of 1:1, and then a composition was prepared by mixing the mixture and butyl benzyl phthalate in a volume ratio of 3 : 1. The composition was injected to fill empty spaces in the array of thermoelectric material legs and cured, thereby forming a filling material.

In the manufactured thermoelectric device, due to the high thermal conductivity of the filling material, thermoelectrical efficiency was degraded.

[Comparative Example 7]

While the same commercially available device as used in Example 1 was used, the characteristics of the thermoelectric device were evaluated by changing the filling material to silicone-based rubber. At this time, as a precursor for the silicone-based rubber, polydimethylsiloxane (Sylgard 184 produced by Dow Corning) was used, and the polydimethylsiloxane was mixed with n-butyl benzyl phthalate at a ratio of 3 : 2, thereby preparing a composition. The composition was injected into empty spaces in the array of thermoelectric material legs and cured, thereby forming a filling material.

The manufactured thermoelectric device had high adhesive strength, but thermal conductivity of the filling material was slightly high and flexibility and tensile strength were low.

[Comparative Example 8]

A substrate on which a P-type thermoelectric material was formed and a substrate on which an N-type thermoelectric material was formed were manufactured in the same method as in Example 7.

Subsequently, a mixture was prepared by measuring Vytaflex30 produced by Smooth-On, Inc. as a major material (part A) and a curing agent (part B) in a volume ratio of 1:1, and then a composition was prepared by mixing the mixture and butyl benzyl phthalate in a volume ratio of 3 : 1. While the composition was applied to an electrode of

a substrate and cured, a filling material was formed to have a height of 1/5 the height of the thermoelectric material legs, and then two substrates were adhered to manufacture a thermoelectric device in which the array of thermoelectric material legs was formed.

The manufactured thermoelectric elements exhibited low thermal conductivity because the filling material was not completely filled, and the filling material was not entirely connected, and the electrode and only a portion of the thermoelectric material were bonded by the filling material, and thus adhesive strength and physical strength were significantly degraded, such that the thermoelectric device could not maintain a shape thereof when the ceramic substrate was removed.

[Table 1]

| | Viscosity (cps) | Thermal conductivity (W/m·K) | $Z_{Tair}$ (K-1) | $ZT_{filter}$ (K-1) | $ZT_{variation}$ (%) | Adhesive strength (MPa) | Porosity (vol%) |
|---|---|---|---|---|---|---|---|
| Example 1 | 370 | 0.031 | 0.678 | 633 | 6.6 | 0.232 | 75 |
| Example 2 | 15 | .031 | 0.67 | 625 | 6.7 | 0.228 | 75 |
| Example 3 | 99 | .031 | 0.66 | 616 | 6.7 | 0.221 | 75 |
| Example 4 | 21 | .031 | 0.66 | 617 | 6.5 | 0.223 | 75 |
| Example 5 | 66 | .031 | 0.714 | 67 | 6.2 | 0.218 | 75 |
| Example 6 | 70 | .031 | 0.535 | 5 | 6.5 | 0.258 | 76 |
| Example 7 | 70 | .031 | 0.67 | 63 | 6.0 | 0.223 | 75 |
| Comparative Example 1 | ,000 | .031 | Not fully filled | | | | |
| Comparative Example 2 | 27 | .031 | Not fully filled | | | | |
| Comparative Example 3 | 37 | .031 | 0.67 | | | Impossible to measure | Impossible to measure |
| Comparative Example 4 | 16 | .031 | 0.68 | | 7.1 | 0.151 | 75 |
| Comparative Example 5 | 14 | .031 | 0.66 | | 6.8 | 0.183 | 75 |
| Comparative Example 6 | 75 | .12-0.18 | 0.66 | | 15.2 | 0.201 | <1 |
| Comparative Example 7 | 32 | .154 | 0.65 | | 20 | 0.265 | <1 |
| Comparative Example 8 | 70 | .025 | - | Impossible to measure | - | Impossible to measure | Impossible to measure |

As described in Table 1, in Examples 1 to 7 for manufacturing a thermoelectric device according to an example of the present invention, as a foam was used as a filling material, the thermal conductivity of the filling material was considerably decreased to 0.05 W/m·K or less, and as such a polyurethane foam with low thermal conductivity was used as a filling material, a drop in the thermoelectric performance index before and after filling with the filling material as maintained at approximately 6.6-6.6%, resulting in very high thermoelectric efficiency. Particularly, in Example 7 using a bulk-type material as a thermoelectric material, the drop in the thermoelectric performance index was maintained at approximately 6.0%, resulting in considerably excellent thermoelectric efficiency.

On the other hand, in Comparative Examples 1 and 2 without using butyl benzyl phthalate or using a very small amount of butyl benzyl phthalate, due to very high viscosity of the foam composition, the foam composition is not smoothly injected to fill the thermoelectric device, and the polyurethane foam is formed before empty spaces in the array of thermoelectric material legs are fully filled with the foam composition after foaming started approximately 40 seconds after the preparation of the foam composition, and thus the thermoelectric device is not properly manufactured. In Comparative Example 3 using too much butyl benzyl phthalate, since a viscosity was sufficiently low, but the ratio of a

foam precursor substantially foamed was relatively low, the polyurethane foam was not properly formed, thereby reducing the mechanical strength of the filling material. For this reason, the polyurethane foam was easily torn, resulting in damage to the device.

Meanwhile, in Comparative Examples 4 and 5, the viscosity of the foam composition was lowered to a suitable level by the addition of polyethylene glycol, and the filling and foaming processes smoothly progressed. As a result, the drop in the thermoelectric figure of merit (ZT) before and after filling with the filling material was maintained at approximately 6.8-7.1%, thereby exhibiting excellent thermoelectric efficiency. However, as a low adhesive strength between the filling material and the electrode was less than 0.2 MPa, in long-term use, the filling material and the electrode are separated, and the thermoelectric device was damaged.

In Comparative Examples 6 and 7, polymeric materials that did not undergo a foaming process were injected to completely fill inner spaces of the thermoelectric device and exhibited high thermal conductivity, and thus the drop in ZT before and after filling with the filling material was maintained at approximately 15.2-20%, thereby exhibiting very low thermoelectric efficiency.

In the case of Comparative Example 8, since the filling material was not completely filled, air was introduced into the filling material to exhibit low thermal conductivity, and the filling material was not entirely connected and was adhered to the electrode and a portion of the thermoelectric material, such that the adhesive strength and the physical strength were degraded and the thermoelectric device could not maintain a shape thereof when the ceramic substrate was removed.

FIG. 4 is a set of images showing flexible thermoelectric devices manufactured according to Example 1 and Comparative Example 7, and FIG. 5 is a graph showing the internal resistance variation (%) of a device according to the radius of curvature of the flexible thermoelectric devices manufactured according to Example 1 and Comparative Example 7.

Hereinafter, a flexible conductive laminate of the present invention and a manufacturing method thereof will be described with reference to the accompanying drawings including FIGS. 1, 3, 7 and 8.

FIG. 7 is a cross-sectional view of a flexible conductive laminate according to one embodiment of the present invention, and FIG. 8 is a cross-sectional view of a flexible conductive laminate according to another embodiment of the present invention.

Meanwhile, in the following description, the flexible conductive laminate included a flexible polyurethane-based foam, but the above-described various foams could be used instead of the flexible polyurethane-based foam.

The flexible conductive laminate according to the present invention includes a metal film, and a flexible polyurethane-based foam formed on one surface of the metal film, and the flexible conductive laminate according to one embodiment of the present invention may include a flexible polyurethane-based foam, thereby exhibiting an excellent thermal insulating effect.

Particularly, the flexible conductive laminate according to the present invention may have not only an excellent insulating effect, but also excellent flexibility and physical stability, and thus can be applied to a flexible conductive device. An example of the flexible conductive device may be a flexible thermoelectric device.

Likewise, for the flexible conductive laminate having excellent flexibility and physical stability, the flexibility of a metal film, the flexibility of a flexible polyurethane-based foam and adhesive strength between the metal film and the flexible polyurethane-based foam, and the restoring force of the flexible conductive laminate are mostly important. When the flexibility of the metal film or the flexible polyurethane-based foam is lowered, the flexibility of the flexible conductive laminate may also be degraded, and when the metal film and the flexible polyurethane-based foam have excellent flexibility, but the adhesive strength between the metal film and the foam or the restoring force is lowered, the metal film and the flexible polyurethane-based foam may be separated, or the shape of the flexible conductive laminate may vary according to repeated application of a high level of physical deformation.

Referring to FIG. 1 again, in the upper image of FIG. 1, it can be seen that a dense polyurethane film is formed on an external surface of the flexible polyurethane-based foam adhered to the metal film, and in the lower image of FIG. 1, it can be seen that a porous structure such as a sponge is formed by foaming polyurethane into the flexible polyurethane foam. Here, for example, the porous structure of the flexible polyurethane-based foam may have a honeycomb structure as shown in FIG. 3 again.

Specifically, the flexible conductive laminate according to one embodiment of the present invention may have adhesive strength between the metal film and the flexible polyurethane-based foam of 0.2 MPa or more. In this range, the metal film and the flexible polyurethane-based foam may not be easily separated and may be stably maintained. More specifically, the adhesive strength between the metal film and the flexible polyurethane-based foam may be 0.2 to 5 MPa, and more specifically, 0.2 to 3 MPa. On the other hand, when the adhesive strength between the metal film and the flexible polyurethane-based foam is less than 0.2 MPa, in an environment in which a high level of physical deformation is repeatedly applied, it is not preferable that the metal film and the flexible polyurethane-based foam may be separated from each other.

In addition, the flexible conductive laminate according to one embodiment of the present invention may have

a very small allowable radius of curvature of 5 mm or less, and thus have very high flexibility. The allowable radius of curvature means the radius of curvature at the maximum degree of bending the flexible conductive laminate, and the radius of curvature refers to the radius of a circle formed with only a curved part when the flexible conductive laminate is bent. That is, even when bent to a radius of curvature of less than 5 mm, the flexible conductive laminate may maintain its shape without being damaged. More preferably, the allowable radius of curvature of the flexible conductive laminate may be 3 mm or less, and the lower limit is not particularly limited, but may be 0.5 mm or more.

In addition, the flexible conductive laminate according to one embodiment of the present invention may have a bending recovery ratio (%) satisfying the following Equation 1.

[Equation 1]

$$80 \leq (C_2/C_1) \text{ X } 100$$

(In Equation 1, $C_1$ is the radius of curvature (mm) before a bending test for the flexible conductive laminate, and $C_2$ is the radius of curvature (mm) after repeating a bending test 10,000 times until the radius of curvature of the flexible conductive laminate reached 5 mm and 10-minute recovery.)

Like this, the flexible conductive laminate according to the present invention may prevent a change in the shape of the laminate due to very high restoring force even though a high level of physical deformation is repeatedly applied by bending 10,000 times until the radius of curvature reached 3 mm. The flexible conductive laminate has preferably a bending recovery rate (%) of 85% or more, more preferably 90% or more, and even more preferably 95 to 100%. In addition, when the flexible conductive laminate is not bent before the bending test, the radius of curvature may be considered as half of the length of a test specimen.

Moreover, in the flexible conductive laminate according to one embodiment of the present invention, the variation of internal resistance may be measured at 5% or less, preferably 3% or less, and substantially approximately 2% until the radius of curvature is 3 mm in measurement of the variation of internal resistance according to the radius of curvature of the flexible conductive laminate, and since the flexible conductive laminate has excellent flexibility even at very high bending strength, a metal film may not be damaged, and therefore the flexible conductive laminate can be operated even at a high level of physical deformation and may have very high usability when applied to a flexible conductive device.

As described above, since the flexible conductive foam according to the present invention has excellent flexibility, an excellent restoring force and excellent adhesive strength between the metal film and the flexible polyurethane-based foam, when applied to the flexible conductive device, the mechanical stability of the device may be maintained even in an environment in which a high level of physical deformation is repeatedly applied so as to stably operate the device for a long time, and therefore, the reliability of the device may be enhanced.

The physical properties and thickness of the metal film, and the physical properties and thickness of the flexible polyurethane-based foam are very important for the flexible conductive laminate according to one embodiment of the present invention to have excellent flexibility, an excellent restoring force and excellent adhesive. Accordingly, the metal film and flexible polyurethane-based foam according to the present invention will be described in further detail.

The metal film according to one embodiment of the present invention may be processed to be a thin film of a metal material having electrical conductivity with a suitable thickness. As described above, since the metal film has a suitable thickness, it may have sufficient flexibility, and enough physical stability not to be easily damaged even at repeated bending deformation. On the other hand, when the thickness of the metal is very high, the metal film and the flexible conductive laminate including the same may be decreased in flexibility, and when the thickness of the metal is very low, the metal film may be easily damaged by repeated bending deformation, resulting in destruction of a stacked structure. In one embodiment, the thickness of the metal film which can ensure excellent flexibility and physical stability may be 10 to 100 $\mu$m, and preferably 20 to 50 $\mu$m. In this range, the flexible conductive laminate may not only have excellent flexibility, but also prevent a damage to the metal film even at a high level of physical deformation. However, when the thickness of the metal film is very low, resistance may be increased, and the electrical property of the flexible conductive device may be degraded, and when the thickness of the metal film is very high, flexibility may be degraded.

In the flexible conductive foam according to one embodiment of the present invention, the metal film may not be particularly limited as long as it is processed to be a film of a metal material having electrical conductivity. For example, the metal film may be formed of a material similar to that of the above-described conductive metal film.

Here, the metal film may be processed into a film type, or processed into a film type using a metal paste, and is more preferably processed into a film type to prevent damage caused by a high level of physical deformation. The metal paste used in the metal film may be, for example, similar the above-described paste for an electrode.

More details on this will be described in a method of manufacturing a flexible conductive laminate described below.

The flexible polyurethane-based foam according to one embodiment of the present invention may be formed

by applying a foam composition on a metal film, and curing and foaming the composition, and may be one having excellent flexibility and excellent adhesive strength with the metal film.

In one exemplary embodiment of the present invention, the flexible polyurethane-based foam for excellent flexibility may have a glass transition temperature (Tg) lower than room temperature (approximately 25°C), and thus is preferably flexible and elastic, and specifically, for example, the flexible polyurethane-based foam preferably has a glass transition temperature (Tg) of 0°C or less, more preferably, -20°C or less, and even more preferably -30°C or less. Here, the glass transition temperature of the flexible polyurethane-based foam may be a glass transition temperature by a soft segment, and the lower limit of the glass transition temperature is not particularly limited, but conventionally, the lowest glass transition temperature of a polyurethane-based resin may be considered as the lowest limit, for example, -150°C or higher.

Meanwhile, in an exemplary embodiment of the present invention, the foam composition may include a foam precursor and a foam. To ensure the flexible polyurethane-based foam having excellent flexibility, as the foam precursor included in the foam composition, a compound having a low glass transition temperature (Tg) may be used.

The foam precursor is not particularly limited as long as it is a material capable of forming a flexible polyurethane-based foam having flexibility and excellent adhesive strength with a metal film after foaming, but is preferably a material capable of satisfying required physical properties. Specifically, the foam precursor may be selected in consideration of the flexibility, physical strength, foaming level, and porosity of the flexible polyurethane-based foam.

Meanwhile, in some cases, as the foam precursor, instead of the polyurethane-based foam, various precursors used in the above-described foam composition, including a silicone-based foam or polyolefin-based foam, can also be used.

To form the flexible polyurethane-based foam, the foam precursor may include a polyurethane-based polymer or polyurethane-based prepolymer.

The flexible polyurethane-based foam may be formed by foaming the polyurethane-based polymer or polyurethane-based prepolymer. The polyurethane-based prepolymer may be a compound containing a curable functional group (curing group) and having a relatively low degree of polymerization, which may be a polyurethane-based prepolymer or monomer before curing and foaming. Some or all of the curing groups of the prepolymer may be cured, thereby forming the flexible polyurethane-based foam. In addition, when the flexible polyurethane-based foam is formed using the polyurethane-based polymer, the polyurethane-based polymer may refer to a pre-foamed polymer, and the polyurethane-based polymer may be formed by polymerizing the polyurethane-based prepolymer.

For example, the foam precursor may be the first and second types of the above-described urethane-based foam precursors. Since the first- and second-type have been described above, detailed descriptions on these will be omitted.

Preferably, the flexible polyurethane-based foam according to one embodiment of the present invention may be a polyisocyanate-based compound, which is manufactured from the foam composition including an aromatic polyisocyanate. Accordingly, excellent adhesive strength, flexibility and mechanical stability may be ensured, and particularly, the preferable aromatic polyisocyanate may be 4,4'-diphenylmethane diisocyanate (MDI) or 2,4-diphenylmethane diisocyanate.

At this time, any polyol-based compound which can form a flexible polyurethane-based foam with excellent flexibility may be used without particular limitation, and preferably an aliphatic polyol is used. The aliphatic polyol having a long hydrocarbon chain unlike a polyol including an aromatic group may have an enhanced soft segment characteristic over the entire polyurethane-based foam, such that the flexible polyurethane-based foam may have excellent flexibility and an excellent restoring force. In other words, the flexible polyurethane-based foam according to one embodiment of the present invention may be manufactured from the foam composition including the aliphatic polyol.

More specifically, an aliphatic polyester polyol may be a polyol having polyethylene adipate, polybutylene adipate, poly(1,6-hexaadipate), polydiethylene adipate or poly(e-caprolactone) as a main chain, and an aliphatic polyether polyol may be a polyol having polyethylene glycol, polypropylene glycol, poyltetramethylene glycol or poly(ethyleneglycol-co-propyleneglycol) as a main chain.

Preferably, the aliphatic polyol may be an aliphatic polyalkylene carbonate polyol, and more preferably, an aliphatic polyalkylene carbonate diol. The adliphatic polyalkylene carbonate diol has a very low glass transition temperature (Tg), and thus can ensure ultimately excellent flexibility in manufacture of the flexible polyurethane-based foam. As a non-limiting embodiment, the aliphatic polyalkylene carbonate diol may be polyethylene carbonate diol, polypropylene carbonate diol or polybutylene carbonate diol. Here, the glass transition temperature of the aliphatic polyalkylene carbonate diol may be, for example, 0°C or less, more preferably, -20°C or less, and even more preferably -30°C or less, and the lower limit may be -150°C or more, but the present invention is not particularly limited.

Moreover, the foam composition according to an exemplary embodiment of the present invention may further include a crosslinking agent for curing the prepolymer, a catalyst and a mixture thereof. Contents of the prepolymer, the crosslinking agent and the catalyst may be selected in consideration of a degree of curing of the pre-designed flexible polyurethane-based foam. Details on the crosslinking agent and the catalyst have been described above.

In the above-described range, when the contents of the crosslinking agent and the catalyst are used, the flexible polyurethane-based foam having excellent flexibility and adhesive strength may be effectively formed, and therefore, despite frequent physical deformation, a flexible conductive device having excellent stability may be realized.

According to an exemplary embodiment of the present invention, the foaming agent is preferably controlled to have different types and contents according to required physical properties of the foam, and any foaming agent which is conventionally used in the art may be used without particular limitation.

Since specific examples of the foaming agent have been described above, detailed descriptions for these will be omitted.

In one embodiment, the flexible polyurethane-based foam may have a foaming rate of 3- to 10-fold. Here, the foaming rate may refer to a degree of foaming the foam composition into a flexible polyurethane-based foam, and a volume (apparent volume) of the flexible polyurethane-based foam may be divided by a volume (apparent volume) of the foam composition. In other words, the foaming rate of 3 to 10 folds means that the foam composition is foamed into a flexible polyurethane-based foam to increase a volume (apparent volume) 3- to 10-fold. More preferably, the flexible polyurethane-based foam may have a foaming rate of 4- to 8-fold. In this range, because of an excellent insulating effect, excellent flexibility and excellent mechanical strength, the physical stability of the flexible polyurethane-based foam may be enhanced.

Accordingly, the flexible polyurethane-based foam may have considerably high porosity, but may be controlled to have a certain level or more of physical strength. In one embodiment, the porosity of the flexible polyurethane-based foam (apparent porosity) may be 50 to 98 vol%, and more preferably 70 to 90 vol%. In this range, as sufficient physical strength is provided, it is possible to prevent the flexible polyurethane-based foam from being easily damaged.

In addition, according to an exemplary embodiment of the present invention, the flexible polyurethane-based foam is preferably maintained in flexibility and physical strength even in an environment to which a high level of physical deformation is applied, and therefore, hardness (shore OO) and tensile strength of the flexible polyurethane-based foam are preferably controlled. In one embodiment, the hardness (shore OO) of the flexible polyurethane-based foam may be 20 to 70, and preferably 30 to 50, which is preferable for higher flexibility. In addition, in one embodiment, a tensile strength may be 30 to 300 $kg/cm^2$, and more preferably, 40 to 90 $kg/cm^2$.

In addition, according to an exemplary embodiment of the present invention, a thickness of the flexible polyurethane-based foam may vary according to an intended shape, but as a non-limiting embodiment, the thickness of the flexible polyurethane-based foam may be 0.1 to 10 mm, and more preferably 0.3 to 5 mm. In this range, the flexible polyurethane-based foam may have excellent flexibility and physical strength, and also have an excellent insulating effect.

Meanwhile, the flexible conductive laminate according to one embodiment of the present invention may further include a thermal conduction layer formed on the opposite side of the metal film. In addition, the flexible conductive laminate may have a structure in which a thermal conduction layer, a metal film and a flexible polyurethane-based foam are sequentially stacked.

The thermal conduction layer is a layer for effectively conducing heat as it is, and is preferably formed of a material having high thermal conductivity and non-conductivity or low electrical conductivity. Specifically, as a material for the thermal conduction layer, a nitride of a transition metal, an oxide of a transition metal or a thermal conductive polymer may be used. As a non-limiting embodiment, aluminum nitride (AlN), silicon nitride ($Si_3N_4$), alumina ($Al_2O_3$), polyimide, polyester, an epoxy resin or a silicone-based resin may be used, but the present invention is not limited thereto. This is for transferring heat of the metal film, but not current, with the thermal conduction layer, and when the thermal conduction layer is formed of a material with high electrical conductivity and applied to the device, the device may have defects.

The thermal conduction layer according to one embodiment of the present invention may be a thermal conductive polymer film, and when the thermal conduction layer is formed of a thermal conductive polymer film, compared to the flexible conductive laminate formed of the thermal conduction layer formed of a nitride of a transition metal or an oxide of a transition metal, much higher flexibility may be ensured. In addition, as the thermal conductive polymer film and the metal film are physically in contact with each other, after repeated bending of the flexible conductive laminate, an excellent recovery ratio and excellent durability may be ensured, and the electrical insulation may be further enhanced.

In one exemplary embodiment of the present invention, the thickness of the thermal conduction layer may be, but is not particularly limited, 5 to 100 $\mu$m, preferably 10 to 50 $\mu$m, and more preferably 15 to 30 $\mu$m, which is preferable for effective transfer of heat, and maintenance of flexibility of the flexible conductive laminate.

In addition, the flexible conductive laminate according to a non-limiting embodiment of the present invention may further include a second thermal conduction layer formed on the flexible polyurethane-based foam. In other words, the flexible conductive laminate may have a structure in which a thermal conduction layer, a metal film, a flexible polyurethane-based foam and a second thermal conduction layer are sequentially stacked. At this time, the second thermal conduction layer and the thermal conduction layer may be formed independently, and may be the same as or different from each other.

In addition, since the second thermal conduction layer may be formed on a top surface of the flexible foam, but

has to receive heat of the metal film, the thermal conduction layer may be physically connected with the metal film with a spacer capable of transferring heat, and the spacer may be used without being particularly limited as long as it is a thermal conductive material.

Hereinafter, a method of manufacturing a flexible conductive laminate according to one embodiment of the present invention will be described in further detail.

The method of manufacturing a flexible conductive laminate according to one embodiment of the present invention may include: a) forming a metal film on a sacrificial substrate; b) forming a flexible polyurethane-based foam on the metal film; and c) removing the sacrificial substrate.

First, the operation a) forming a metal film on a sacrificial substrate may be performed.

As a metal film, a transition metal which has high electrical conductivity and high adhesive strength with the flexible polyurethane-based foam may be used.

This metal film may be a film processed into a film type, or a film formed by processing a conductive metal paste. To manufacture the film, various methods of manufacturing a metal film may be used, and may be similar to the above-described method of preparing a paste for an electrode. The manufactured metal film may be used by suitably cutting it into an intended shape.

In one embodiment, as to be described below, a metal film having a desired pattern may be formed by adhering the metal film processed into a film type to a thermal conductive polymer film, which is a thermal conduction layer, through lamination, and then etching, and the metal film formed by the above-described method may be fixed to a sacrificial substrate, thereby manufacturing a flexible conductive laminate. The etching process may be any conventionally-used method without particular limitation, which may be a physical or chemical etching method, such as dry etching or wet etching. In one embodiment, when a copper film is etched by a chemical etching method to form a patterned copper film, the chemical etching method may be performed using a copper etching solution conventionally used to etch copper, but the etching method is not limited thereto.

Alternatively, when a metal paste is used, a metal film may be formed by a method such as screen printing or spin coating. Specifically, the metal paste may be applied to a substrate and then thermally treated, thereby forming a metal film.

Specifically, the metal paste may include a conductive material, and particularly, contain a conductive material, a solvent and a binder. In one example, the composition and content of each component of the metal paste may be controlled in consideration of the intended type, thermal conductivity, electrical conductivity and thickness of the metal film. In one embodiment, the metal paste may include 10 to 90 wt% of a conductive material, 5 to 50 wt% of a solvent and 2 to 10 wt% of a binder with respect to the total weight.

In one embodiment of the present invention, a shape of the conductive material is not particularly limited, and may particularly include isotropic particles, anisotropic particles, or mixed particles of isotropic particles and anisotropic particles. When the conductive material is isotropic particles such as spherical particles, it may have a high space-filling property, and exhibit uniform and stable electrical properties. In addition, when the conductive material is anisotropic particles such as rod-shaped, fiber-shaped, plate-shaped or flake-shaped particles, due to anisotropicity, one particle may be in contact (linked) with a large number of other particles. Accordingly, when the metal film contains anisotropic particles, even in the state of the flexible conductive laminate being physically and highly deformed, a decrease in electrical conductivity of the metal film may also be prevented. In addition, when the conductive material includes both isotropic particles and anisotropic particles, in consideration of a degree of anisotropicity of the anisotropic particles (as an example, an aspect ratio in the case of rod-shaped or fiber-shaped particles, a thickness-to-width ratio in the case of plate-shaped or flake-shaped particles, etc.), relative contents of these particles may be suitably controlled within in a range of effectively expressing advantages of anisotropic particles and advantages of isotropic particles. In one example, anisotropic particles may be mixed at 1 to 50 parts by weight with respect to 100 parts by weight of isotropic particles.

In one embodiment, when the conductive material is spherical isotropic particles, the particles may have an average particle size of 10 nm to 100 $\mu$m, preferably 100 nm to 50 $\mu$m, and more preferably 0.5 to 20 $\mu$m, which is preferable for a high space-filling property, realization of a thinner metal film, and further enhancement in weight reduction and flexibility. When the conductive material is fiber-shaped anisotropic particles, a contact area between particles may be enhanced, and thus efficiency may be enhanced in terms of electrical conduction and thermal conduction. In one embodiment, the aspect ratio of the anisotropic particles (the ratio of a minor axis to a major axis or the ratio of thickness to width) may be 2 to 1000, and preferably 10 to 500.

In one embodiment of the present invention, the solvent is used to control the flowability of the metal paste, and may be any one that can dissolve a binder without particular limitation, and in one embodiment, an alcohol-based solvent, a ketone-based solvent or a mixed solvent thereof may be used. The binder may be used to control printing resolution, and in one embodiment, the binder may be a resin-based material.

In one embodiment of the present invention, the sacrificial substrate may serve as a support that maintains the shape of the flexible conductive laminate before the completion of the flexible conductive laminate, and may include any material with low adhesive strength between the metal film and the thermal conduction layer without limitation to its type,

and the material, shape and size of the substrate are not limited. In one embodiment, the sacrificial substrate may be any one selected from silicon, silicon oxide, sapphire, alumina, mica, germanium, silicon carbide and a polymer thereof. In addition, when the adhesive strength between the sacrificial substrate and the metal film is high, the sacrificial substrate may further include a sacrificial film. As the sacrificial film, a second metal film or polymer film which has poor adhesive strength with the sacrificial substrate without particular limitation, and in one embodiment, the second metal film may be a nickel film. The polymer film may be formed from a polymer adhesive. Specific examples of polymer adhesives have been described above.

In this case, in the method of manufacturing a flexible conductive laminate according to one embodiment of the present invention, the operation a) may be performed by forming a metal film on one surface of a thermal conduction layer, and adhering a thermal conduction layer on which the metal film is formed to a sacrificial substrate. Specifically, as described above, the operation a) may be performed by adhering a metal film processed into a film type to one surface of a thermal conduction layer through lamination and forming a metal film having an intended pattern through an etching process, and adhering the thermal conduction layer on which the patterned metal film is formed on a sacrificial substrate.

In one embodiment of the present invention, the thermal conduction layer may be previously formed into a film type, and any known method can be used without limitation. In one embodiment, a thermal conduction layer may be formed by spin coating, screen printing, physical deposition (sputtering), thermal deposition (thermal evaporation), chemical vapor deposition, electrodeposition or spray coating, and it will be appreciated by those of ordinary skill in the art that the method may vary depending on the composition of a thermal conduction layer.

Subsequently, the operation b) of forming a flexible polyurethane-based foam on the metal film may be performed, and specifically, a flexible polyurethane-based foam may be formed by applying the foam composition on the metal film, and curing and foaming the composition. The foam composition has been described in detail above, and an overlapping description is omitted.

A method of applying the foam composition may not be particularly limited as long as it is conventionally used in the art, and spin coating may be used. Alternatively, when a flexible polyurethane-based foam is formed between the metal film and the second thermal conduction layer, a flexible polyurethane-based foam may be formed by injecting the foam composition between the metal film and the second thermal conduction layer and curing and foaming the foam composition. Here, to inject the foam composition between the metal film and the second thermal conduction layer, a spacer may be formed between the metal film and the second thermal conduction layer. A method of forming a spacer may be any known method without particular limitation, and for example, screen printing may be used.

In one embodiment of the present invention, in curing and foaming of the foam composition, the foaming process may be performed under conditions, for example, at 20 to 150°C for 1 minute to 1 hour, and more preferably 40 to 100°C for 5 to 30 minutes, but the present invention is not particularly limited thereto.

Subsequently, a flexible conductive laminate may be manufactured by performing the operation c) of removing the sacrificial substrate.

For the operation c), any method that can peel only the sacrificial substrate from the metal film may be used without particular limitation, and for example, the sacrificial substrate may be peeled by applying a physical or chemical force in air or water. Alternatively, in the case of the sacrificial substrate on which the sacrificial film is formed, after a part of the sacrificial substrate excluding the sacrificial film is first peeled by the above-described method, the sacrificial substrate may be completely removed by removing the sacrificial film. In one embodiment, the flexible conductive laminate from which the sacrificial substrate is not removed may be immersed in a water vessel to first remove a part of the sacrificial substrate excluding the sacrificial film, and the sacrificial film may be removed by etching. Here, an etching method is not particularly limited, and the sacrificial film may be removed by wet etching and/or physicochemical grinding. Preferably, the sacrificial film may be removed by wet etching, and at this time, the composition of an etching solution may vary according to the type of a metal film of the sacrificial film.

Hereinafter, the flexible conductive laminate according to the present invention and a manufacturing method thereof will be described with reference to the following examples in further detail. However, the following examples are intended to illustrate the present invention in detail, and are not to be construed as limiting the scope of the present invention. In addition, unless particularly defined otherwise, all technical and scientific terms have the same meaning as commonly understood by one of ordinary skill in the art to which the present invention belongs. The terms used herein are merely provided to effectively describe specific examples, and are not intended to limit the present invention. In addition, singular forms used in the specification and the accompanying claims are intended to include plural forms as well unless particularly indicated in the context. Further, the units of additives which are not particularly mentioned herein may be wt%.

[Example 8]

A copper (Cu) film having a thickness of 35 μm was adhered onto a polyimide film by lamination. Then, a copper film with a desired pattern was formed by chemical etching using a copper etching solution such as a 0.1M aqueous

ammonium persulfate solution. Subsequently, after the polyimide film formed on the patterned copper film was fixed on an alumina substrate, a foam composition was applied to the copper film, and completely foamed and cured in a 60°C oven for approximately 10 minutes. Afterward, the alumina substrate was peeled off, thereby manufacturing a flexible conductive laminate.

At this time, the foam composition was prepared by measuring and mixing a curing agent (part A), that is, Flexfoam-iT X produced by Smooth-On, Inc. and a major material (part B) in a volume ratio of 1:1.

[Examples 9 and 10]

All processes were performed in the same manner as described in Example 8, except that the thickness of a copper film varied as listed in Table 2.

[Example 11]

Proceeding in the same manner as described in Example 8, a polyimide film on which a patterned copper film was formed was fixed to an alumina substrate, and copper particles having an average particle size of 30 μm, which were used as spacers, were applied to the copper film. Subsequently, the alumina substrate to which the polyimide film (hereinafter, also referred to as a second polyimide film for the ease of identification) was fixed was laminated thereto, the foam composition was injected into the copper film and the second polyimide film, and completely cured and foamed in a 60°C oven for approximately 10 minutes, thereby forming a foam.

Subsequently, the alumina substrate was completely peeled off, thereby manufacturing a flexible conductive laminate.

[Comparative Example 9]

All processes were performed in the same manner as described in Example 8, except that a silicone-based foam, instead of a flexible polyurethane-based foam, was formed on a copper film, and a foam composition was prepared by measuring and mixing a major material (part A), that is, Soma foma15 produced by Smooth-On, Inc. and a curing agent (part B) in a volume ratio of 2:1.

[Comparative Example 10]

All processes were performed in the same manner as described in Example 8, except that polyurethane-based rubber, instead of a flexible polyurethane-based foam, was formed on a copper film, and to form the polyurethane-based rubber, a foam composition was prepared by measuring and mixing a major material (part A), that is, Vytaflex30 produced by Smooth-On, Inc. and a curing agent (part B) in a volume ratio of 1:1.

[Comparative Example 11]

All processes were performed in the same manner as described in Example 8, except that silicon-based rubber, instead of a flexible polyurethane-based foam, was formed on a copper film, and to form the silicone-based rubber, a foam composition was prepared by measuring and mixing a major material (part A), that is, Ecoflex0010 produced by Smooth-On, Inc. and a curing agent (part B) in a volume ratio of 1:1.

[Evaluation of properties]

1) Adhesive strength (MPa): A force for completely peeling an interface was measured by pulling both ends of the adhesive interface between a copper film and a foam (Pull-off test).
2) Allowable radius of curvature (mm): A radius of curvature was measured by bending a flexible conductive laminate using a bending tool, and the lowest radius of curvature at which the flexible conductive laminate was not bent without a damage was defined as an allowable radius of curvature.
3) Bending recovery rate (%): A radius of curvature was measured using a bending tool, and a bending recovery rate was calculated according to the following equation.

$$\text{Bending recovery rate } (\%) = (C_2/C_1) \times 100$$

($C_1$ is the radius of curvature (mm) before a bending test for the flexible conductive laminate, and $C_2$ is the radius of curvature (mm) after a bending test was repeated 10,000 times until the flexible conductive laminate reached 5 mm and recovery for 10 minutes.)

[Table 2]

| | Thickness of copper film (um) | Adhesive strength (MPa) | Allowable radius of curvature (mm) | Bending recovery rate (%) |
|---|---|---|---|---|
| Example 8 | 35 | 0.232 | 3 | 94 |
| Example 9 | 10 | 0.226 | 2 | 96 |
| Example 10 | 50 | 0.229 | 4 | 89 |
| Example 11 | 35 | 0.230 | 4 | 92 |
| Comparative Example 9 | 35 | 0.186 | 10 | Damaged |
| Comparative Example 10 | 35 | 0.201 | 9 | Damaged |
| Comparative Example 11 | 35 | 0.175 | 4 | 90 |

As listed in Table 2, it can be confirmed that Examples 8 to 11 for manufacturing the flexible conductive laminate according to the present invention exhibited a very high adhesive strength between a copper film and a polyurethane foam of 0.2 MPa or more, very high flexibility indicated by the allowable radius of curvature of 4 mm or less, and sufficient elasticity, indicated by the bending recovery rate of 90% or more.

Meanwhile, Comparative Example 9 using a silicone-based foam, instead of a polyurethane foam, exhibited an insufficient adhesive strength, which is less than 0.2 MPa, and an allowable radius of curvature of 10 mm, and therefore, in a test for measuring a bending recovery rate at a radius of curvature of 5 mm, the laminate was damaged during the test due to insufficient adhesive strength and flexibility.

Comparative Example 11 using a silicone-based rubber exhibited excellent flexibility and thus a high allowable radius of curvature of 4 mm, but exhibited insufficient adhesive strength.

On the other hand, Comparative Example 10 using polyurethane-base rubber exhibited a moderate adhesive strength of 0.201 MPa and an allowable radius of curvature of 9 mm, indicating that the laminate was greatly decreased in flexibility, and therefore, like Comparative Example 9, the laminate was damaged during a test for a bending recovery rate.

From the above-described results, it was confirmed that the formation of a flexible polyurethane-based foam on the metal film is the critical factor for ensuring adhesive strength between the metal film and the foam and excellent flexibility.

While the preferred embodiments of the present invention have been described, it is noted that various alternations, modifications, and equivalents may be applied to the present invention and the preferred embodiments may be appropriately modified and applied thereto. Therefore, the above description is not intended to limit the scope of the present invention defined by the appended claims.

Meanwhile, the reference numerals used in the above descriptions and the accompanying drawings are as follows.

1200, 1300 : flexible thermoelectric device
110, 1210', 1310, 1310': contact thermal conduction layer
1220, 1320 : first electrode
1220', 1320': second electrode
1230, 1330 : P-type thermoelectric material
1240, 1340 : N-type thermoelectric material
1250, 1350 : foam

1301, 1301': sacrificial substrate
1302, 1302': sacrificial film
2100 : metal film
2200 : flexible polyurethane-based foam
2300 : thermal conduction layer

[Embodiments of the Invention]

As described above, in the best mode for carrying out the invention, related matters were described.

[Industrial Applicability]

As described above, the present invention can be widely applied in flexible fields to which a flexible thermoelectric device or flexible substrate is applied.

## Claims

1. A foam composition comprising:

    a foam precursor; and
    an ortho-phthalate-based compound represented by Formula 1,
    wherein a volume ratio of the foam precursor to the ortho-phthalate-based compound is 100 : 10 to 50.

    [Formula 1]

    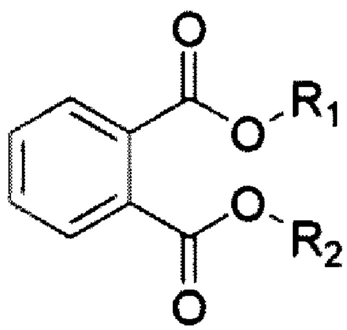

    (In Formula 1, $R_1$ and $R_2$ are each independently any one selected from alkyl having 1 to 20 carbon atoms, cycloalkyl having 6 to 30 carbon atoms, aryl having 6 to 30 carbon atoms, cycloalkylalkyl having 7 to 30 carbon atoms, arylalkyl having 7 to 30 carbon atoms, aryl having 6 to 20 carbon atoms, which is substituted with alkyl having 1 to 10 carbon atoms, and alkyl having 1 to 10 carbon atoms, which is substituted with aryl having 6 to 20 carbon atoms.)

2. The foam composition according to claim 1, wherein $R_1$ and $R_2$ are each independently any one selected from alkyl having 1 to 10 carbon atoms, cycloalkyl having 6 to 20 carbon atoms, aryl having 6 to 20 carbon atoms, cycloalkylalkyl having 7 to 20 carbon atoms and arylalkyl having 7 to 20 carbon atoms.

3. The foam composition according to claim 1, wherein the foam composition has a viscosity of 800 cps or less.

4. The foam composition according to claim 1, wherein the foam precursor includes a polymer or prepolymer, and a foaming agent.

5. The foam composition according to claim 4, wherein the foaming agent is a hydrocarbon-based compound, a nitroso-based compound, an azo-based compound, an azide-based compound, an inorganic foaming agent or water.

6. The foam composition according to claim 4, wherein a foam manufactured from the composition is a polyurethane-based foam, a silicone-based foam or a polyolefin-based foam.

**7.** A flexible thermoelectric device comprising a foam manufactured from the foam composition of any one selected from claims 1 to 6.

**8.** The flexible thermoelectric device according to claim 7, wherein the flexible thermoelectric device comprises an array of thermoelectric material legs including one or more of an N-type thermoelectric material and a P-type thermoelectric material, which are spaced apart from each other; an electrode electrically connecting the thermoelectric materials of the array of thermoelectric material legs; and a foam injected to fill at least empty space in the array of thermoelectric material legs.

**9.** The flexible thermoelectric device according to claim 7, wherein the foam has a porosity of 50 to 98 vol%.

**10.** The flexible thermoelectric device according to claim 7, wherein the foam has a thermal conductivity of 0.1 W/m·K or less.

**11.** A method of manufacturing a flexible thermoelectric device, comprising:
forming a foam by foaming the foam composition of any one selected from claims 1 to 6.

**12.** The method of manufacturing a flexible thermoelectric device according to claim 11, comprising:

a) forming a first structure in which a first sacrificial substrate, a first contact thermal conduction layer, a first electrode, and a P-type thermoelectric material formed at a predetermined region on the first electrode are sequentially stacked, and a second structure in which a second sacrificial substrate, a second contact thermal conduction layer, a second electrode, and an N-type thermoelectric material formed at a predetermined region on the second electrode are sequentially stacked;
b) manufacturing a substrate having an array of thermoelectric material legs formed by physically connecting the first structure and the second structure;
c) filling a foam composition and forming a foam into empty spaces in the array of thermoelectric material legs of the substrate; and
d) removing the first sacrificial substrate and the second sacrificial substrate.

**13.** The method of manufacturing a flexible thermoelectric device according to claim 12, wherein the operation c) comprises:

c-1) injecting a foam composition into empty spaces in the array of thermoelectric material legs of the substrate; and
c-2) forming a foam by curing and foaming the foam composition.

**14.** A flexible conductive laminate, comprising:

a metal film; and
a flexible polyurethane-based foam formed on one surface of the metal film.

**15.** The flexible conductive laminate according to claim 14, wherein adhesive strength between the metal film and the flexible polyurethane-based foam is 0.2 MPa or more.

**16.** The flebixle conductive laminate according to claim 14, wherein an allowable radius of curvature is 5 mm or less.

**17.** The flexible conductive laminate according to claim 14, wherein the flexible conductive laminate has a bending recovery rate (%) satisfying the following Equation 1:

[Equation 1]

$$80 \leq (C_2/C_1) \text{ X } 100$$

(In Equation 1, $C_1$ is the radius of curvature (mm) before a bending test for the flexible conductive laminate, and $C_2$

is the radius of curvature (mm) after 10,000 times bending tests until the radius of curvature of the flexible conductive laminate reached 5 mm and 10-minute recovery.)

**18.** The flexible conductive laminate according to claim 14, further comprising:
a thermal conduction layer formed on the opposite side of the metal film.

**19.** The flexible conductive laminate according to claim 18, wherein a material of the thermal conduction layer is any one or two or more selected from a nitride of a transition metal, an oxide of a transition metal, and a thermal conductive polymer.

**20.** The flexible conductive laminate according to claim 14, wherein the flexible polyurethane-based foam is manufactured from the foam composition including an aliphatic polyol in a repeat unit.

**21.** The flexible conductive laminate according to claim 20, wherein the aliphatic polyol is any one or two or more selected from an aliphatic polyester polyol, an aliphatic polyether polyol and an aliphatic polyalkylene carbonate polyol.

**22.** The flexible conductive laminate according to claim 14, wherein the metal film has a thickness of 10 to 100 μm.

**23.** The flexible conductive laminate according to claim 14, wherein the flexible polyurethane-based foam has a glass transition temperature (Tg) of 0 °C or less.

**24.** The flexible conductive laminate according to claim 14, wherein the flexible polyurethane-based foam has a foaming rate of 3- to 10-fold.

**25.** A method of manufacturing a flexible conductive laminate, comprising:

a) forming a metal film on a sacrificial substrate;
b) forming a flexible polyurethane-based foam on the metal film; and
c) removing the sacrificial substrate.

【Fig. 1】

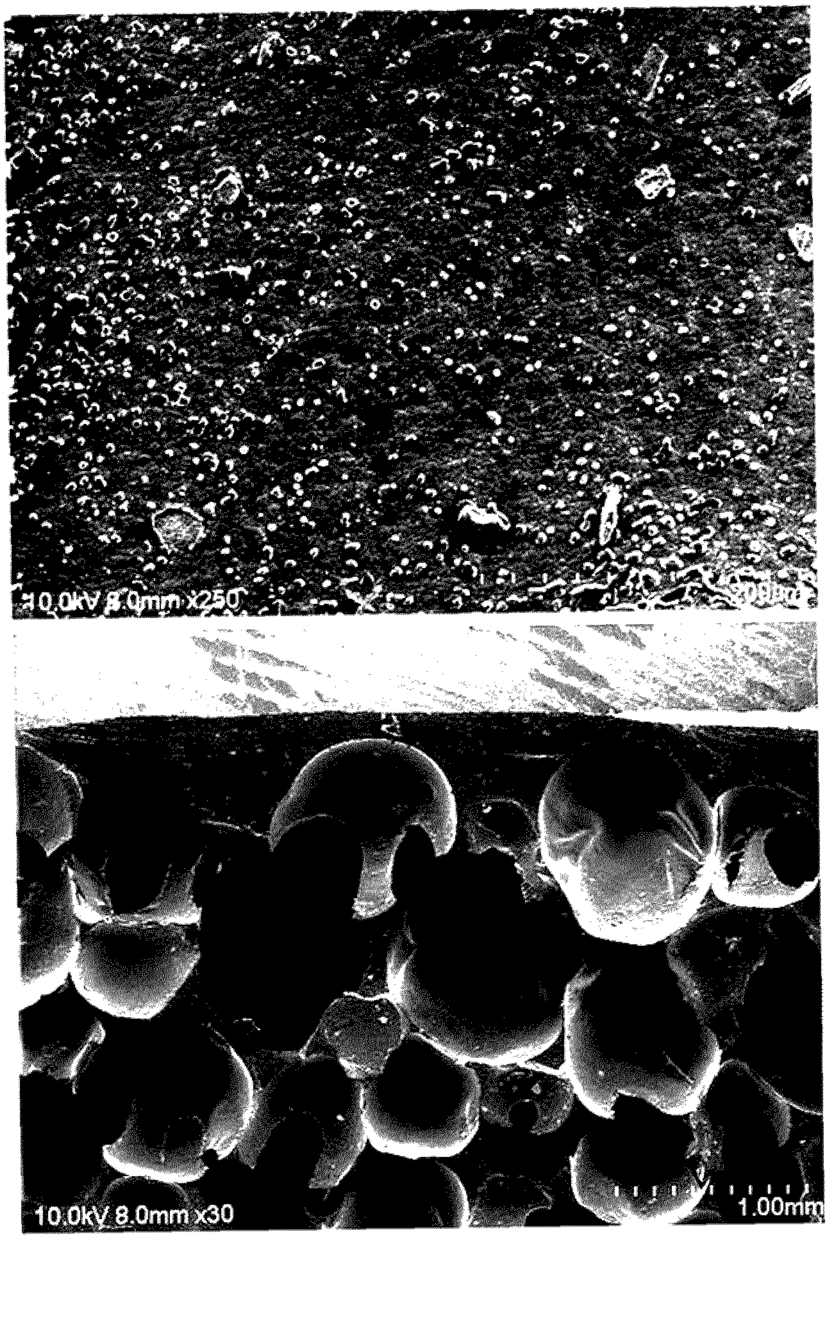


(a)

(b)

【Fig. 2】

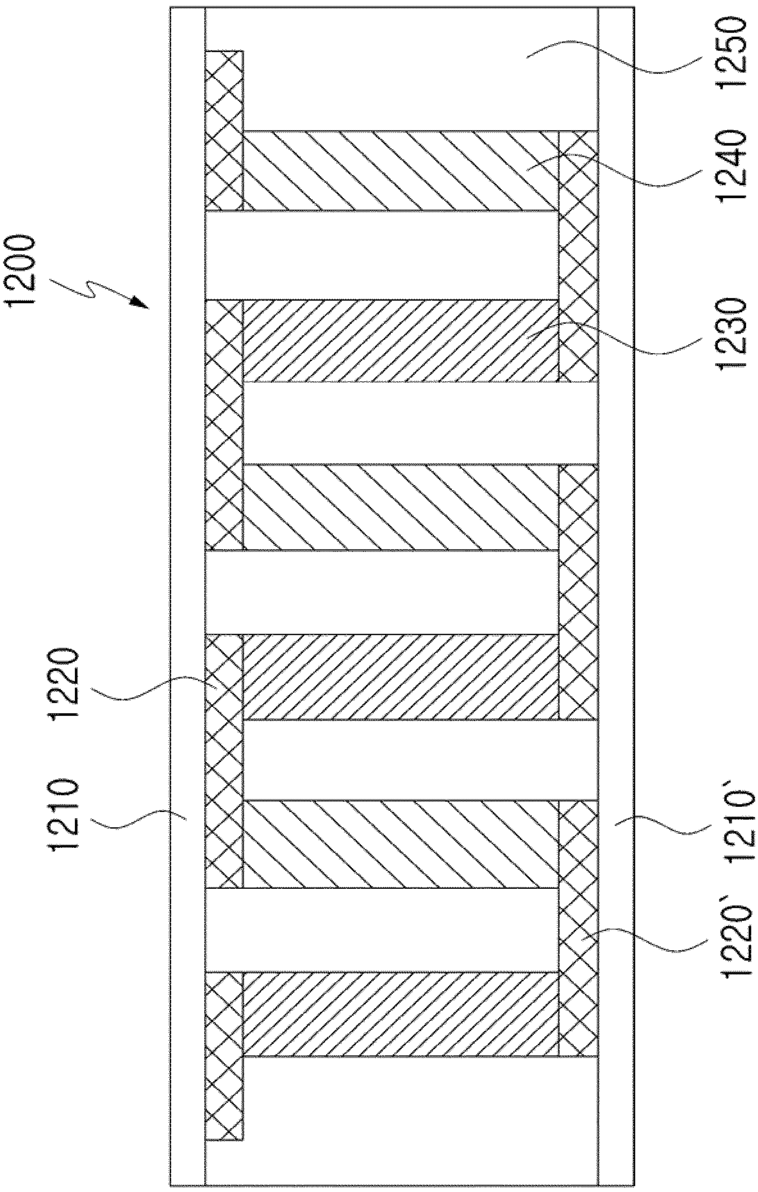

【Fig. 3】

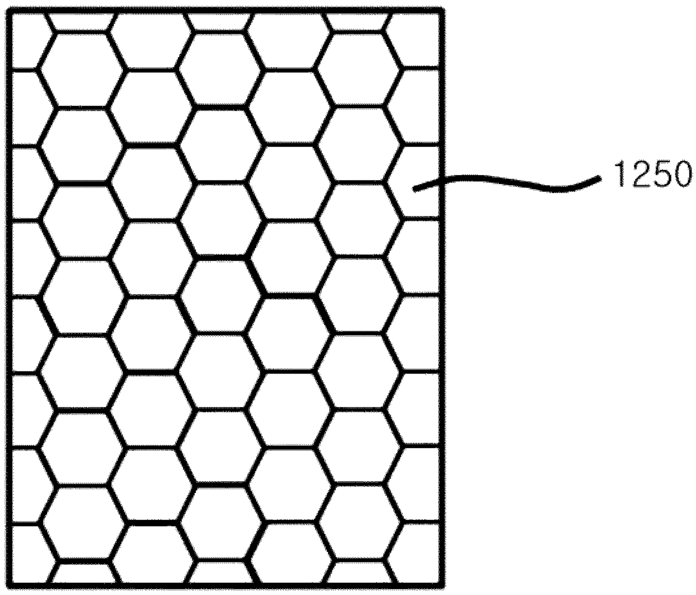

【Fig. 4】

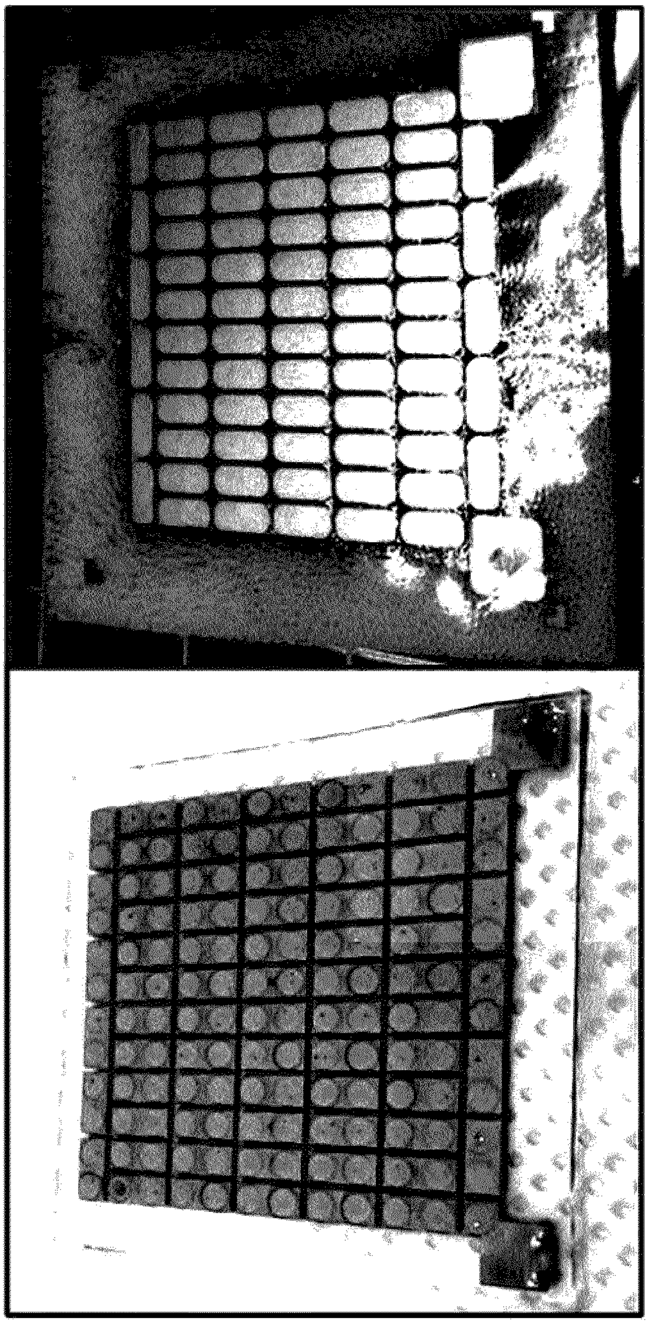

< Example 1 >

< Comparative Example 7 >

【Fig. 5】

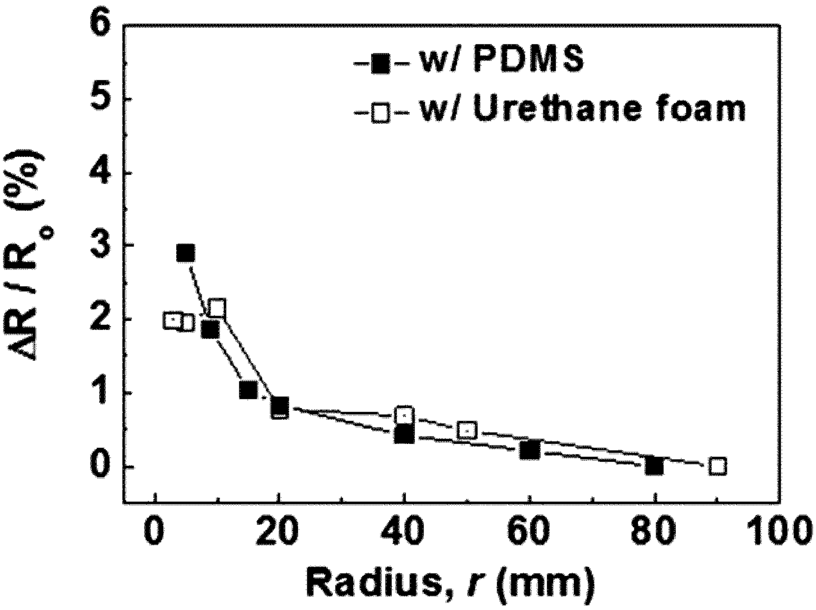
w/ PDMS
w/ Urethane foam
ΔR / R_o (%)
Radius, r (mm)
0
1
2
3
4
5
6
0
20
40
60
80
100

【Fig. 6】

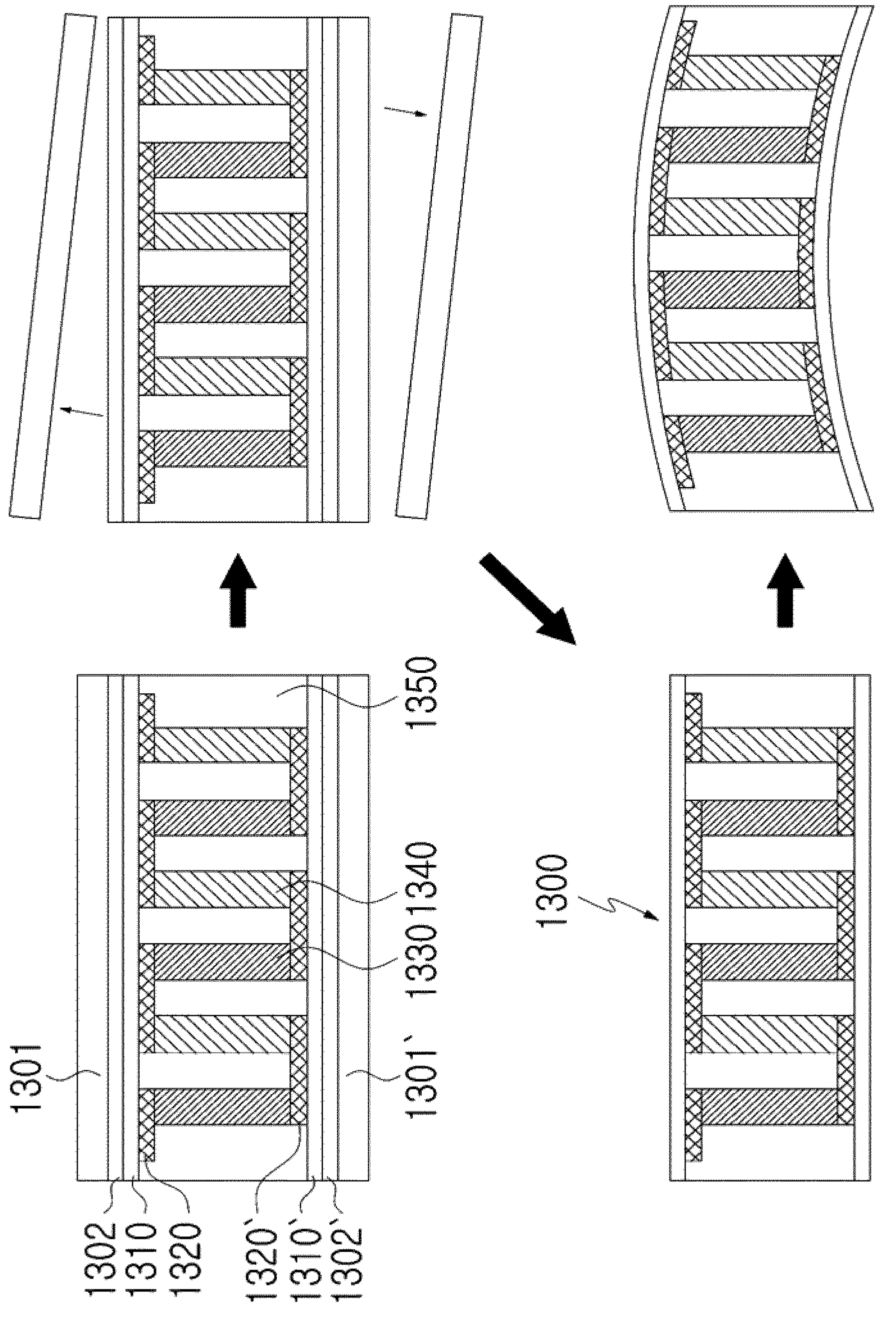

【Fig. 7】

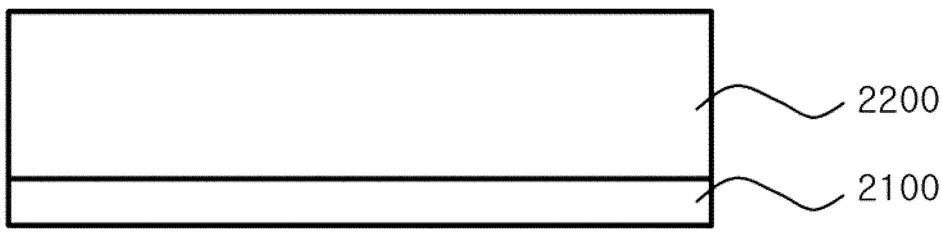

【Fig. 8】

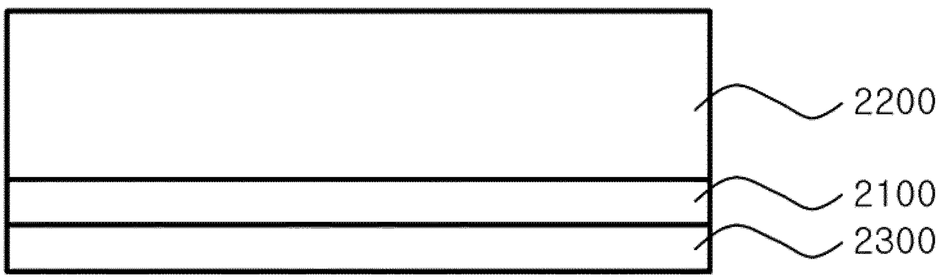

INTERNATIONAL SEARCH REPORT

International application No.
PCT/KR2017/015695

A. CLASSIFICATION OF SUBJECT MATTER
*B32B 15/04(2006.01)i, B32B 5/18(2006.01)i, B32B 9/04(2006.01)i, B32B 15/08(2006.01)i, C08J 9/00(2006.01)i, C08K 5/092(2006.01)i*
According to International Patent Classification (IPC) or to both national classification and IPC

B. FIELDS SEARCHED
Minimum documentation searched (classification system followed by classification symbols)
B32B 15/04; B29D 7/01; H01L 23/373; B29C 43/24; H05K 7/20; H01L 35/16; H01L 35/32; C08L 23/00; C08J 9/00; C08J 9/04; B32B 5/18; B32B 9/04; B32B 15/08; C08K 5/092

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)
eKOMPASS (KIPO internal), STN Express (Registry, Caplus), Google & Keywords: thermoelectric element, foaming body, ortho-phthalate, flexible, polyurethane, metal foil

C. DOCUMENTS CONSIDERED TO BE RELEVANT

| Category* | Citation of document, with indication, where appropriate, of the relevant passages | Relevant to claim No. |
|---|---|---|
| X<br>Y | US 2003-0158275 A1 (MCCLELLAND, A. N. R. et al.) 21 August 2003<br>See abstract; paragraphs [0009]-[0013], [0033], [0034]; claim 13. | 1-6<br>7-13 |
| Y | JP 2003-258323 A (CITIZEN WATCH CO., LTD.) 12 September 2003<br>See abstract; claims 1, 2; paragraphs [0001], [0018], [0021], [0031]-[0033]; figures 1, 2. | 7-13 |
| Y | KR 10-2010-0120883 A (S&K POLY TEC CO., LTD.) 17 November 2010<br>See abstract; claims 1, 4, 6, 7; paragraphs [0003], [0035]-[0040]; figure 1-(A). | 14-25 |
| Y | KR 10-2014-0000159 A (NITTO DENKO CORPORATION) 02 January 2014<br>See abstract; claims 1-7; paragraphs [0021], [0025], [0056], [0067], [0186]; figure 1. | 14-25 |
| A | JP 04-004236 A (TONEN CHEM CORP.) 08 January 1992<br>See the entire document. | 1-25 |
| A | NEMA, A. K. et al., "Effect of Exo- and Endothermic Blowing and Wetting Agents on Morphology, Density and Hardness of Thermoplastic Polyurethanes Foams", Journal of Cellular Plastics, 2008, vol. 44, no. 4, pages 277-292. | 1-25 |

☐ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 26 APRIL 2018 (26.04.2018) | **26 APRIL 2018 (26.04.2018)** |
| Name and mailing address of the ISA/KR<br>Korean Intellectual Property Office<br>Government Complex-Daejeon, 189 Seonsa-ro, Daejeon 302-701, Republic of Korea<br>Facsimile No. +82-42-481-8578 | Authorized officer<br><br>Telephone No. |

Form PCT/ISA/210 (second sheet) (January 2015)

INTERNATIONAL SEARCH REPORT

International application No.
PCT/KR2017/015695

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:

The invention of group 1 (claims 1 to 13): a foam composition containing a foam precursor and an ortho-phthalate-based compound represented by [chemical formula 1]; a flexible thermoelectric device including the same; and a manufacturing method of the flexible thermoelectric device

The invention of group 2 (claims 14 to 25): a flexible conductive laminate including a metal foil and flexible polyurethane-based foam formed on one surface of the metal foil; and a manufacturing method therefore

1. ☒ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☒ No protest accompanied the payment of additional search fees.

Form PCT/ISA/210 (continuation of first sheet (2)) (January 2015)

INTERNATIONAL SEARCH REPORT
Information on patent family members

International application No.
PCT/KR2017/015695

| Patent document cited in search report | Publication date | Patent family member | Publication date |
|---|---|---|---|
| US 2003-0158275 A1 | 21/08/2003 | AU 6908001 A | 05/02/2002 |
| | | BR 0112622 A | 01/07/2003 |
| | | CN 1443214 A | 17/09/2003 |
| | | EP 1174458 A1 | 23/01/2002 |
| | | EP 1303560 A1 | 23/04/2003 |
| | | JP 2004-504463 A | 12/02/2004 |
| | | MX PA03000443 A | 24/06/2003 |
| | | WO 02-08323 A1 | 31/01/2002 |
| JP 2003-258323 A | 12/09/2003 | NONE | |
| KR 10-2010-0120883 A | 17/11/2010 | NONE | |
| KR 10-2014-0000159 A | 02/01/2014 | CN 103507355 A | 15/01/2014 |
| | | EP 2676793 A1 | 25/12/2013 |
| | | JP 2014-007246 A | 16/01/2014 |
| | | JP 5906140 B2 | 20/04/2016 |
| | | TW 201416430 A | 01/05/2014 |
| | | US 2013-0344308 A1 | 26/12/2013 |
| JP 04-004236 A | 08/01/1992 | NONE | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 101646366
- KR 101493797